# EUROPÄISCHE PATENTSCHRIFT

(11) **EP 1 711 843 B1**
(45) Veröffentlichungstag und Bekanntmachung des Hinweises auf die Patenterteilung: **28.05.2014**
(21) Anmeldenummer: 05716601.9
(22) Anmeldetag: 27.01.2005
(51) Int. Cl.: G01S 5/06, G01W 1/16, G01R 29/08

(54) **SYSTEM UND VERFAHREN ZUM ERFASSEN, ÜBERMITTELN UND AUSWERTEN VON DURCH ELEKTROMAGNETISCHE STRAHLUNG ANFALLENDEN DATEN UND INFORMATIONEN**
SYSTEM AND METHOD FOR THE RECORDING TRANSMISSION AND ANALYSIS OF DATA AND INFORMATION GENERATED BY ELECTROMAGNETIC RADIATION
SYSTEME ET PROCEDE POUR DETECTER, TRANSMETTRE ET EVALUER DES DONNEES ET DES INFORMATIONS GENEREES PAR UN RAYONNEMENT ELECTROMAGNETIQUE

(30) Priorität: 29.01.2004 DE 102004004580; 09.02.2004 DE 102004006253; 09.07.2004 DE 102004033386; 18.08.2004 DE 102004000025
(43) Veröffentlichungstag der Anmeldung: 18.10.2006
(73) Patentinhaber: nowcast GmbH, 81377 München (DE)
(72) Erfinder: OETTINGER, Wolf, Peter, 81927 München (DE)
(74) Vertreter: Hofmann, Andreas
(86) Internationale Anmeldenummer: PCT/EP2005/050355
(87) Internationale Veröffentlichungsnummer: WO 2005/073752

(56) Entgegenhaltungen:
- DE-A1- 4 133 209
- DE-A1- 19 826 122
- US-B1- 6 246 367
- US-B1- 6 735 525
- SCHULZ W ET AL: "SITE-ERROR-KORREKTUR BEI EINEM BLITZORTUNGSSYSTEM MIT MAGNETIC-DIRECTION-FINDERN. ÖTEIL 1: METHODEN DER SITE-ERROR-KORREKTUR" ELEKTROTECHNIK UND INFORMATIONSTECHNIK, SPRINGER VERLAG, WIEN, AT, Bd. 110, Nr. 5, Januar 1993 (1993-01), Seiten 239-248, XP000361391 ISSN: 0932-383X
- H.-D. BETZ , K. SCHMIDT, W. P. OETTINGER, AND M. WIRZ: "TOTAL VLF/LF-LIGHTNING AND PSEUDO 3D-DISCRIMINATION OF INTRA-CLOUD AND CLOUD-TO-GROUND DISCHARGES" 18TH INTERNATIONAL LIGHTNING DETECTION CONFERENCE, [Online] 7. Juni 2004 (2004-06-07), XP002326501 Gefunden im Internet: URL:http://www.vaisala.com/DynaGen_Attachm ents/Att33737/33737.pdf> [gefunden am 2005-04-26]
- DIENDORFER G ET AL: "ALDIS - DAS OESTERREICHISCHE BLITZORTUNGSSYSTEM" ELEKTROTECHNIK UND INFORMATIONSTECHNIK, SPRINGER VERLAG, WIEN, AT, Bd. 109, Nr. 5, Januar 1992 (1992-01), Seiten 261-266, XP000304331 ISSN: 0932-383X

## Beschreibung

### Technisches Gebiet

Die vorliegende Erfindung betrifft ein System sowie ein Verfahren zum Erfassen, Übermitteln und Auswerten von durch elektromagnetische Strahlung anfallenden Daten und Informationen (vgl. Druckschrift US 6 246 367 B1 aus dem Stand der Technik).

### Stand der Technik

Seit über zehn Jahren befinden sich Blitzortungssysteme weltweit im Einsatz und erlauben die Lokalisierung von Bodenblitzen mit zunehmender örtlicher Genauigkeit, die bei modemen Netzen im Bereich von unter einem Kilometer liegt Die Nachwelseffizienz wird für Beize mit einer Stärke von mehr als fünf Kiloampere mit meist über neunzig Prozent angegeben, bei schwächeren Blitzen sind allerdings keine statistisch verlässlichen Daten bekannt.

Traditionell sind die operationellen Netze so konzipiert, dass vorwiegend Bodenblitze (= CG oder Cloud-Ground) gemeldet und Wolke-Wolke-Blitze (= I[ntra]C[loud] innerhalb einer Gewitterwolke oder C[loud-]C[loud] zwischen Gewitterwolken) möglichst unterdrückt werden. Neuerdings verstärkt sich allerdings der Trend, auch Entladungen in den Wolken zu Zwecken meteorologischer Nutzung mit zu erfassen.

Eine Unterscheidung von CG-Blitzen und IC-/CC-Blitzen ist mit speziellen Methoden, insbesondere mit dreidimensionalen Verfahren (sogenannte 3D-Verfahren), möglich, wobei auch Messungen im V[ery]H[igh]F[requenzy]-Bereich und im V[ery]L[ow]F[requency]-Bereich miteinander kombiniert werden können [vgl. Kawasaki, Z.-l. et al. (1994), "SAFIR operation and evaluation of its performance", Geophys. Res. Lett. 21(12), Seiten 1133 bis 1166; Thery, C. (2001), "Evaluation of LPATS data using VHF Interferometric observations of lightning flashes during the EULINOX experiment", Atmospheric research 56, Selten 397 bis 409].

Im Aufsatz von Jacobson et al. (2000), "FORTE radio-frequency observations of lightning strokes detected by the National Lightning Detection Network", J. Geophys. Res. 105, Seiten 15653 bis 15662, wird beispielsweise ein dreidimensionales Verfahren beschrieben, bei dem eine dreidimensionale Peilung zunächst mit VHF-Radiofrequenzen erfolgt und daraufhin über zeitliche Koinzidenz das zugehörige VLF-Signal aus einem vorhandenen zweidimensionalen VLF-Netz (sogenanntes NLDN) gesucht wird.

Weiterhin beschreiben Smith et al. (1999) im Aufsatz "A distinct class of isolated intracloud lightning discharges and their associated radio emissions", J. Geophys. Res. 104, Seiten 4189 bis 4212, ein dreidimensionales Verfahren, das jedoch eine reine VHF-Peilung ohne jeden VLF-Bezug vorsieht

Ein dreidimensionales Verfahren mit guter Auflösung von Entladungskanälen beschreiben Krehbiel et al. (1999) in der Veröffentlichung "Three-dimensional lightning mapping observations during MEAPRS in central Oklahoma", 11th Int. Conf. on Atmosph. Electricity, NASA/CP, Alabama, Juni 1999, Seiten 376 bis 379. Dieses Verfahren weist jedoch wiederum keinen VLF-Bezug auf und beruht rein auf VHF-Peilung in den Wolken.

Bereits sehr frühzeitig wird in dem Dokument von Taylor (1978), "A VHF technique for space-time mapping of lightning discharge processes", J. Geophys. Res. 83, Seiten 3575 bis 3583, die Möglichkeit direkter räumlicher Anpeilung von hohen Emissionsorten mittels Laufzeitmessungen aufgezeigt.

Bei diesem bekannten Verfahren werden mittels zweier eng benachbarter Stationen, die jeweils auch zwei Sensoren in vertikaler Anordnung benötigen (unter anderem bodennah und in einer Höhe von etwa fünfzehn Metern) Laufzeitunterschiede im Nanosekunden-Bereich gemessen und hiermit die Elevationswinkel ermittelt, deren Schnittpunkt mittels Triangulation die Emissionsorte gibt.

Weitere dreidimensionale Verfahren werden in folgenden Dokumenten beschrieben:
- Richard and Auffray (1985), "VHF-UHF interferometric measurements, applications to lightning discharge mapping'', Radio Science 20, Seiten 171 bis 192;
- Rhodes et al. (1994), "Observations of lightning phenomena using radio interterometry", J. Geophys. Res. 99, Seiten 13059 bis 13082;
- Laroche et al. (1996), "3D structure of lightning discharge within storms", 10th Int. Conf. Atmosph. Electrcity, Osaka, 10. Juni 1996 bis 14. Juni 1996, Seiten 330 bis 332;
- Onuki et al. (1996), "Imaging of lightning channel in three dimensions using interferometer", 10th Int Conf. Atmosph. Electricity, Osaka, 10. Juni 1996 bis 14. Juni 1996, Seiten 325 bis 332; und
- Richard and Lojou (1996), "Assessment of application of storm cell electrical activity monitoring to intense precipitation fore-cast",10th Int. Conf. Atmosph. Electricity, Osaka, 10. Juni 1996 bis 14. Juni 1996, Seiten 284 bis 287.

Die weltweit über großen Flächen eingesetzten Ortungsverfahren basieren jedoch auf weniger aufwändigen zweidimensionalen Systemen (sogenannte 2D-Systeme), bei denen sich die CG-Blitz- versus IC-/-CC-Blitz-Unterscheidung schwieriger gestaltet Einige Hersteller berichten zwar von impulsformabhängigen zuverlässigen Unterscheidungsverfahren, insgesamt ist die Literatur zu dieser Problematik jedoch äußerst widersprüchlich.

### Darstellung der Erfindung: Aufgabe, Lösung, Vorteile

Ausgehend von den vorstehend dargelegten Nachteilen und Unzulänglichkeiten sowie unter Würdigung des umrissenen Standes der Technik liegt der vorliegenden Erfindung die Aufgabe zugrunde, ein System der eingangs genannten Art sowie ein Verfahren der eingangs genannten Art so weiterzuentwickeln, dass eine genaue Charakterisierung der Impulsquelle, zum Beispiel eine zuverlässige Unterscheidung zwischen Wolke-Boden-Blitzen (C[loud]G[round]) und Wolke-Wolke-Blitzen (= I[ntra]C[loud] innerhalb einer Wolke oder C[loud-]C[loud] zwischen Wolken), gewährleistet ist.

Diese Aufgabe wird gemäß der Lehre der vorliegenden Erfindung durch ein System mit den im Anspruch 1 angegebenen Merkmalen sowie durch ein Verfahren mit den im Anspruch 10 angegebenen gelöst. Vorteilhafte Ausgestaltungen und zweckmäßige Weiterbildungen der vorliegenden Erfindung sind in den jeweiligen Unteransprüchen gekennzeichnet.

Mithin liegt der Kern der vorliegenden Erfindung in der dreidimensionalen Peilung von Impulsabgaben/-aussendungen natürlichen und/oder nichtnatürlichen Ursprungs, insbesondere von Blitzen, von Ladungsabgaben, von Ladungsaussendungen oder von dergleichen, in V[ery]L[ow]F[requency]-Netzwerken; insbesondere ist keine Nutzung von Frequenzen im Radio- oder V[ery]H[igh]F[requency]-Bereich erforderlich.

Zur Abgrenzung von konventionellen, bereits bekannten Peilverfahren gilt für die vorliegende Erfindung, dass die Peilung nicht mit nur einer oder zwei der Impulsquelle nahen, insbesondere blitznahen, Sensoren auf direkte Weise, das heißt nicht durch ortsnahes Anpeilen In die Höhe erfolgt, sondern durch Nutzung von Abweichungen der Signal-Ankunftszeiten an den jeweils der Impulsquelle nächstgelegenen, insbesondere blitznächsten, Sensorstationen gegenüber anderen, der Impulsquelle nicht nächstgelegenen, insbesondere nicht blitznächsten, Sensorstationen.

Demzufolge befasst sich die vorliegende Erfindung mit einem neu konzipierten Impulsortungssystem, insbesondere Blitzortungs-system, das im Prinzip zunächst auf den bewährten zweidimensionalen Verfahren (sogenannte 2D-Blitzpeilung) im V[ery]L[owlF[requency]-Bereich basiert.

Hierzu ist anzumerken, dass in zahlreichen Ländern 2D-Blitzortungssysteme in Betrieb sind. Beispielhaft seien das nordamerikanische Netzwerk NALDN in USA [vgl. Orville, R. E. et al. (2002), "The North American Lightning Detection Network (NALDN) - First results: 1998-2000", Monthly Weather Review 130 (8), Seiten 2098 bis 2109] und das europäische Verbundsystem EUCLID erwähnt

Letzteres EUCLID-System entstand aus einem Zusammenschluss des von Siemens betriebenen bundesdeutschen Systems BLIDS (mit US-Sensor-Technik und Netzwerk-Software) und des österreichischen ALDIS-Netzes [vgl.Diendorfer, G. et al. (1994), "Results of a performance analysis of the Austrian Lightning Location Network ALDIS". In: 22nd Int. Conf. on Lightning Protection, Sept. 19-23, Budapest, Hungary] sowie dessen Erweiterung auf zahlreiche andere umliegende Länder.

Diese Netzwerke arbeiten im VLF-Bereich und nutzen die klassischen Methoden der Richtungspellung (sogenanntes D[irection]F[inding]) und/oder der Signal-Laufzeiten (T[ime]O[f]A[rrival]). Die von einer Impulsquelle, insbesondere von einem Blitz, ausgesandte VLF-Strahlung lässt sich bei hinreichender Stärke an mehreren Sensorstationen empfangen. Zur Ermittlung des Quellortes sind dann die an den einzelnen Stationen gemessenen Einfallsrichtungen (DF) und/oder die Laufzeitunterschiede (TOA) nutzbar.

Werden nun die Signale an nur zwei Sensoren festgestellt, liefem die Richtungen einen Pellort, der durch Einbindung der Signal-zeiten optimiert werden kann. Bei Signalerfassung an mehr als zwei Stationen ist die T[ime]O[f]A[rrival]-Methode aus Gründen der Genauigkeit vorzuziehen, weil relativ leicht erreichbare Genauigkeiten von etwa einer Mikrosekunde bereits zu Ortungen von besser als einem Kilometer führen.

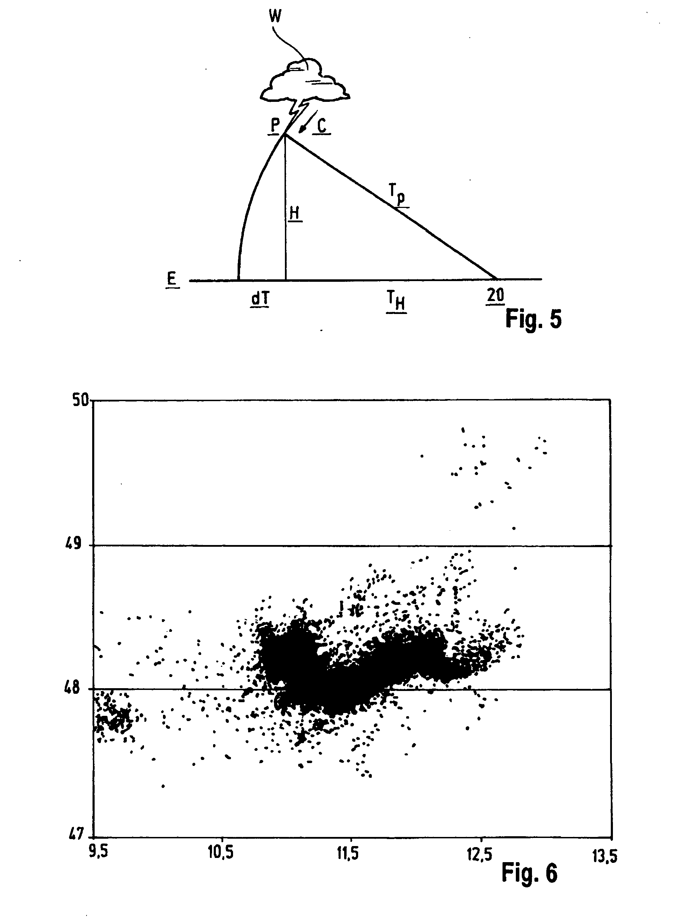

Dementsprechend ist Im schematischen Prinzipbild gemäß Figur 5 die entscheidende, durch I[ntra]C[loud]-Entladungen (im Vergleich zu C[loud]G[round]-Blitzen) bedingte Lautzeitverzögerung dT = T_{P} - T_{H} dargestellt.

Die Einrichtung der Signalbehandlung und der Impulsverarbeltung ist also vorteillhafterweise so angelegt, dass deutlich höhere Zeitgenauigkeiten (besser als eine Mikrosekunde, das heißt kleiner als eine Mikrosekunde) als bei konventionellen Systemen erzielt werden. Diese Genauigkeit ist wesentlich, um nach der Laufzeitmethode Ereignisorte von Impulsen, insbesondere von Blitzen, zu ermitteln.

Mittels des vorteilhafterweise eingesetzten Analyseverfahrens wird auch bei unregelmäßigen Impulsformen eine genaue Zeitbestimmung (besser als eine Mikrosekunde, das heißt kleiner als eine Mikrosekunde) ermöglicht, insbesondere für Signale, die an verschiedenen Sensoren erfasst werden und zum gleichen Impulsereignis, insbesondere zum gleichen Blitzereignis, gehören. Dies kann in erfindungswesentlicher Weise unter anderem durch Muster- und Formerkennungsalgorithmen erreicht werden.

Zum Beispiel in der Netzzentrale werden also mittels besonderer Algorithmen, insbesondere mittels algorithmischer Musterer-kennung, aus den zahlreichen, von den Einzelsensoren eintreffenden Signalen diejenigen herausgefunden, die zum gleichen Impulsereignis gehören.

Zu diesem Zweck werden die von den verschiedenen Einzelsensoren empfangenen Peakmuster in digitalisierter Form "übereinander gelegt", um auf diese Weise den Anfangspeak eindeutig identifizieren zu können. Mittels dieser "Matching"-Methode ist ein zeitlich präzises und mithin gutes Peilengebnis erzielbar, was wiederum wesentlich für die Höhenpeilung ist. Hierdurch kann die hohe Ereignisempfindlichkelt erreicht und die dadurch begründete hohe Anzahl primär erfassbarer Signale tatsächlich weiter genutzt und auch hinsichtlich der Signaleigenschaften zweckdienlich ausgenutzt werden.

Die Herausfilterung von Signalen, die zum gleichen Blitzereignis gehören, ist bei hohem Datenanfall nicht trivial, weil zeitliche Überlappungen auftreten. Ist aber in einer Signalgruppe ein falsches Signal enthalten, kann eine Blitzortung nicht erfolgreich stattfinden. In konventionellen Systemen ist diese Problematik nicht gelöst; dies ist auch daran erkenntlich, dass konventionelle Blilzortungssysteme
- zum einen einen sehr starken Blitz mehrfach melden, weil die Einzelsignale der Sensoren nicht richtig gruppiert werden, und
- zum anderen schwache Signale wegen nicht identischer Impulsformen nicht als zusammengehörig erkennen.
Des Weiteren können bei konventionellen Blitzortungssystemen Fehlpeilungen mit erheblichen Ortsabweichungen auftreten.

Sind mehr als drei Messdaten verfügbar, können die drei zu ermittelnden unbekannten Größen (= die Länge; die Breite; die Impulsabgabezeit, insbesondere die Blitzzeit) mit üblichen Minimalisierungsverfahren errechnet werden. Soweit systematische Fehler ebenfalls in der Größenordnung von etwa einer Mikrosekunde bleiben, lässt sich die genannte Peilgenaulgkeit auch nachhaltig im praktischen Dauerbetrieb erzielen und beispielsweise anhand von Einschlägen In Messtürne verifizieren.

Da das System gemäß der vorliegenden Erfindung wie auch das Verfahren gemäß der vorliegenden Erfindung eine besonders hohe Nachweiseffizienz auch im Bereich schwacher Impulse, insbesondere schwacher Blitze, erzielt und keine Maßnahmen zur Unterdrückung von IC-Enbadungen, insbesondere von IC-Blitzen, angewandt werden müssen, liefert das neue Netz erheblich mehr Entladungsereignisse als konventionelle Vergleichssysteme. Aus diesem Grunde stellt sich in ganz besonderem Maße die Frage nach der Herkunft der Entladungen.

Zu diesem Zweck wird das Netz gemäß der Lehre der vorliegenden Erfindung um einen dreidimensionalen Modus (sogenannter 3D-Modus) erweltert, so dass Emissionshöhen von Impulsen, insbesondere von Entladungen, ermittelt werden können. Damit wird erfindungsgemäß ein neuartiger und entscheidender Beitrag zur identifizierung von IC-/CC-Entladungen, insbesondere von IC-/CC-Biltzen, vorgeschlagen.

Eine derartige Vorgehensweise bletet eine Reihe von technischen wie auch wirtschaftlichen Vorteilen:
- weil nur eine Station impulsquellennah, insbesondere blitznah, sein muss, sind große Sensorabslände möglich, das heißt es ist kein dichtes teures Netz erforderlich;
- aufgrund der Nutzung G[lobal]P[ositioning]S[ystem]-gesteuerter Zeitmessungen können auch noch größere Entfernungen von bis zu etwa einhundert Kilometem zur Blitz-Station als *der Impulsquelle nah* bzw. als "blitznah" gelten und signifikante, das heißt für die Höhenpeilunung nutzbare Zeitabweichungen produzieren:
- die Verwendung von V[ery]L[ow]F[requency]-Messnetzen (= Bereich um zehn Kilohertz) sichert eine große Reichweite der der Impulsquelle nicht nächstgelegenen Messstationen, zum Beispiel der nicht blitznächsten Blilzstationen (, die den Blitz auch noch erfassen müssen), das heißt etablierte VLF-Netze können eingesetzt werden, sofern die Zeitmessungen im Mikrosekundenbereich genau sind;
- das System gemäß der vorliegenden Erfindung wie auch das Verfahren gemäß der vorliegenden Erfindung kann auf der Hardware herkömmlicher 2D-Blitzortungsverfahren aufsetzen; eine Verwendung "echte" 3D-Techniken im Radio- oder VHF-Bereich ist insofern nicht erforderlich, als Ziel der vorliegenden Erfindung nicht die räumlich präzise Auflösung von Entladungskanälen, zum Beispiel von Blitzkanälen, im 100 Meter-Bereich, sondern die Bereitstellung einer Datenbasis für eine Entscheidung hinsichtlich der Frage ist, ob das detektierte Ereignis als I[ntra]C[loud]-Impuls, insbesondere als I[ntra]C[loud]-Blitz, einzustufen ist;
- die Existenz von Impulsabgaben bzw. Impulsaussendungen, insbesondere von Blitzemissionen, aus Kilometer-Höhen lässt sich theoriefrei und ohne Annahme justierbarer Parameter aus einem Vergleich der an einzelnen (, jeweils blitznächsten) Sensoren und an Gruppen von (nicht blitznächsten) Sensoren gemessenen Verteilungen von Zeitabweichungen zweier Impulsabgabazeiten (im Netz durch Gesamtpeilung ermittelte Impulszeit minus Differenz von Ankunftszeit und Laufzeit an der jewelligen der Impulsquelle nächstgelegenen Station), insbesondere zweier Biltzzeiten (im Netz durch Gesamtpeilung ermitteile Blitzzelt minus Differenz von Ankunftszeit und Laufzeit an der Jeweiligen blitznächsten Station). erkennen;
- die Emissionshöhe lässt sich mit Algorithmen, die mit denen der Ortspeilung zumindest vergleichbar sind, durch Hinzufügen der Höhenvariablen berechnen;
- das Verfahren kann in andere existierende Impulsortungssysteme, insbesondere Blitzortungssysteme, integriert werden. sofern die notwendige Zeitgenauigkeit erzielt wird;
- das Verfahren kann auch bei intensitätsschwachen Impulsen, insbesondere bei intensitätsschwachen Blitzen, eingesetzt werden, sofern der Impuls, insbesondere der Blitz, an drei, bei Nutzung von Einfallsrichtungen zur Peilung auch an nur zwei Sensoren gemessen wird;
- die Ergebnisse des Verfahrens können dazu benutzt werden, Fragen einer Impulsform-Diskriminerung von Wolke-Wolke-Entladungen (IC), insbesondere von Wolke-Wolke-Blitzen, gegenüber Wolke-Erde-Entladungen (CG), insbesondere Wolke-Erde-Blitzen, zu klären; und
- das System gemäß der vorliegenden Erfindung wie auch das Verfahren gemäß der vorliegenden Erfindung kann zusammen mit der Impulstorm-Analyse zur Diskriminierung eingesetzt worden, um den (kleinen) Prozentsatz strittiger Fälle zu lösen, der weder mit dem einen Verfahren noch mit dem anderen Verfahren klar entscheidbar ist

Bei einer vorteilhaften Ausfuhrungsform der vorliegenden Erfindung arbeitet der Sensor passiv und ohne Stromversorgung. Dies erspart im Vergleich zu bekannten Systemen Fehlerquellen. Zudem kann der Sensor, wenn er passiv und ohne Stromversorgung arbeitet, deutlich höhere Datenraten verarbeiten, als dies bei früher beschriebenen oder existierenden Systemen aus dem Stand der Technik der Fall war.

Neben den vorstehend dargelegten technischen sowie wirtschaftlichen Vorteilen bietet die vorliegende Erfindung auch eine Reihe von Anwendungsvorteilen, so etwa
- meteorologisch und wolkenphysikalisch wichtige Erkenntnisse über das Auftreten von IC-Blitzen,
- eine höchst sichere Unterscheidung von CG-Blitzen versus IGBlitzen,
- eine bessere identifizierung von CG-Blitzen, was zu wichtigen Folgedaten in Form von zuverlässigeren Blitzdlchte-Karten führt (Verbesserung des Blitzschutzes, was zum Beispiel für die Automobilindustrie, für das Baugewerbe, für Freizeitveran-stalter, für Reiseveranstalter und/oder für die Versicherungswirtschaft interessant ist) oder
- eine Erfassung von wesentlich mehr Blitzen, als herkömmliche Netze melden, was in Zusammenhang mit CG-Identifizierungen zu deutlich höheren Boden-Blitzdichten als bisher angenommen führt

Des Weiteren liefert die vorliegende Erfindung einen Lösungsbeitrag zu einer Reihe von Schwierigkeiten, so etwa
- dem Erfordernis einer genauen Zeitbestimmung auch bei intensitätsschwachen, verrauschten, komplex geformten und/oder übersteuerten Signalen, um eine möglichst quantitative Erfassung und Unterscheidung von Impulsen (I[ntra]C[loud] versus C[loud-]G[round]), insbesondere von Blitzen, zu gewährleisten,
- der Notwendigkeit einer effizienten Erkennung nicht impulskorrelierter, insbesondere nicht blitzkorrelierter, Störsignale,
- dem Erfordernis einer optimalen Einrichtung des Zeitmanagements aller Stations- und Netzkomponenten oder
- der Notwendigkeit einer Benutzung komplexer Algorithmen zur möglichst zuverlässigen Impulsabgabeunterscheldung, insbesondere Entladungsunterscheidung, von echten und statistisch sowie durch systematische Fehler bedingten Zufalls-Höhenpeilungen.

Das Erfordernis der Zeitbestimmung beinhaltet somit gemäß einer vorteilhaften Weiterbildung der vorliegenden Erfindung eine besonders genaue Zeitmarkierung der an den einzelnen Sensoren eintreffenden Signale. Diese Zeltmarkierung erfolgt für Signale des gleichen impulses, insbesondere des gleichen Blitzes, an den verschiedenen Sensorstationen möglichst gleichartig

Aufgrund dieser genauen Zeitmarkierung kann aus den Markierugszeiten ermittelt werden, ob an einem der impulsquele nahen Sensor, insbesondere an einem blitznahen Sensor, - relativ zu den anderen Sensoren - eine verzögerte Signalzeit gemessen wird; falls eine derartige Verzögerung der Signalzeit vorliegt, weist dies auf eine verlängerte Laufstrecke und damit auf eine Herkunft aus großer Höhe hin.

Da dieser auszunutzende Laufzeitunterschied mit zunehmender Distanz zwischen Impulsquellenort, insbesondere Blitzort, und betrachtetem Sensor immer kleiner wird, erfordert eine effiziente Höhenpeilung die Messung und Verwendung sehr kleiner Zeitunterschiede von höchstens etwa einer Mikrosekunde. Bei einer vorteilhaften Ausgestaltung der Erfindung sind daher die Markierungen der einzelnen Signale nicht ungenauer als dieser Zeibunterschied.

Des Weiteren ermöglicht es die vorliegende Erfindung, neue Fragen betreffend die VLF-Emission aus Gewitterwolken zu diskutieren. So ist für die Möglichkeit der Höhenpeilung erfindungswesentlich, dass die Verzögerung der Impuls-Ankunftszeit, insbesondere der Blitz-Ankunftszeit, ihre Ursache in der längeren Laufzeit zur Emissionsquelle hat und nicht durch apparative oder sonstige systematische Fehler verursacht wird. Im Folgenden werden die fünf wichtigsten möglichen Effekte diskutiert, die einen Einfluss auf die Höhenbestimmung haben können:
(i) Zunächst könnte unterstellt werden, dass verzögerte Ankunftszeiten aufgrund von Systemfehlem rein statistisch verteilt auftreten und keine physikalische Bedeutung haben. Da die in Rede stehenden Verzögerungen Je nach Distanz zur Impulsquelle, insbesondere zum Blitz, meist mehrere Mikrosekunden betragen, müssten relativ große Zeitfehler unterstellt werden, die aufgrund der nachweislich genauen Peilungen auszuschließen sind.
   Ferner würde man dann erwarten, dass Fehler mit kleineren Verzögerungszeiten häufiger auftreten und die resultierende Höhenverteilung entgegen den tatsächlichen Ergebnissen zu geringen Höhen der Impulsquelle, insbesondere zu niedrigen Blitzhöhen, nahe Null stark zunimmt
   Eine Untersuchung der Zeitabstände zwischen ermittelter Impulsabgabe- oder-aussendungszeft, Insbesondere ermittelte Blitzzeit, und den aus den Einzelstationen gemäß Ankunftszeit und Laufzeit zum Ort der impulsquelle, insbesondere zum Blitzort resultierenden Impulsabgabe- oder -aussendungszelten, insbesondere Blitzzeiten, ergeben erfindungsgemäß keinerlei systematische Abweichungen der Zeitmeldungen einer Station relativ zur Gesamtheit der Stationen.
(ii) Signalverzögerungen an einer Sensorstation können durch elektronische Effekte zustande kommen und an den verschiedenen Stationen unterschiedlich stark ausgeprägt sein.
   Wäre dies der Fall, würde die 3D-Peilung in praktisch allen Fällen zu fiktiven, stationsbezogen unterschiedlichen Impulsquellenhöhen, Insbesondere Blitzhöhen, führen und nicht nur bei einem Bruchteil der Signalgruppen. Zudem wäre dieser Fehler in der Prüfung gemäß vorstehendem Punkt (i) zu entdecken.
(iii) Falsche Ankunftszeiten können durch fehlerhafte Auswertung der eintreffenden Signale verursacht sein; insbesondere bei Impulsen mit mehreren signifikanten Extremwerten oder bei nicht aufgelösten Doppelpeak-Strukturen könnte eine falsche Zeitmarkierung entstehen.
   Bei noch gut aufgelösten Peaks würde ein solcher Fehler jedoch in der Regel zum gegenteiligen Effekt führten (-> zu frühe Ankunftszeit anstatt zu später Ankunftszeit), weil die impulsnächste, insbesondere blitznächste, Station, das stärkste Signal empfängt und daher kaum zu erwarten ist, dass der erste relevante Signalpeak unterdrückt und statt dessen der zweite ("verzögerte") Peak zur Zeitmarkierung erfasst wird.
   Bei schlecht aufgelösten Doppelstrukturen könnte allerdings bei der impulsnächsten, insbesondere blitznächsten, Station das Maximum im zeitlich späteren Teil liegen, während bei weiter entfernten Stationen infolge von Dämpfungs- und Ausbreitungseffekten die Struktur nicht mehr aufgelöst und ein früheres Maximum in der Mitte des Gesamtpeaks gefunden wird. Die Signalauswertung gemäß der vorliegenden Erfindung berücksichtigt und löst derartige Probleme.
(iv) Die Sensoren können insbesondere bei nahen Impulsquellen, insbesondere bei nahen Blitzen, übersteuern und daher keine oder verfälschte Zeitmarkierungen und Einfallsrichtungen melden.
   Es wird über vorhandene Ortungsnetze häufig berichtet, dass zur Vermeldung solcher Komplikationen der Impulsquelle nahe Stationen, insbesondere blitznahe Stationen, bei der Auswertung nicht berücksichtigt werden. Für eine 3D-Peilung würden dann die Interessantesten informationen verloren gehen.
   Die Empfangsstationen gemäß der vorliegenden Erfindung sind daher auf hohe Intensitätsauflösung mit großem Dynamikbereich ausgelegt - ohne bei schwächsten Signalen unempfindlich zu werden -, und die Impulsbehandlung kann auch gesättigte Signale in zuverlässiger Weise verarbeiten. Dies ist dadurch erleichtert, dass das Feld B(t) und nicht die Ableitung dB/dt gemessen wird, so dass Integrationsprozeduren entfallen.
(v) Es ist wohlbekannt, dass lokale "site-errors" zur Verfälschung der gemessenen Einfallsrichtungen führen; weniger ist über die damit verbundenen Zeitfehler berichtet worden.
   Sollten diese Zeitfehler den Bereich von etwa einer Mikrosekunde übersteigen, was durchaus vorstellbar erscheint, würden sich zwar nicht zwingend gravierende Fehler in der 2D-Lokalisierung des Netzes, jedoch fiktive Emissionshöhen in der dreidimensionalen Ortung ergeben. Ein solcher Effekt würde dann bei nahezu allen Signalen auftreten und dadurch feststellbar sein (vgl. vorstehender Punkt (i)).

In Anbetracht der vorstehenden Befunde kann bei der vorliegenden Erfindung davon ausgegangen werden, dass die hier vorgestellten 3D-Peilungen reale Laufzeitvernögerungen signalisieren, die durch Emission in den Gewitterwolken anstatt in Bodennähe entstehen.

Die erfindungsgemäß ermittelten Höhen der Impulsquellen, insbesondere Blitzhöhen, sind auch mit der Geometrie typischer Gewitterwolken gut verträglich. Da allgemein und aus guten Gründen angenommen wird, dass CG-Entladungen, insbesondere CG-Blitze, nahe am Boden die Hauptausstrahlung im VLF-Bereich erzeugen, ist die Schlussfolgerung naheliegend, dass es sich bei den 3D-Peilungen um negative und positive IC-Entladungen, insbesondere IC-Blitze, handelt, die eine starke vertikale Entladungsrichtung aufweisen.

Eher horizontal ausgerichtete IC- oder CC-Entladungen, zum Beispiel IC- oder CC-Blitze, dürften wegen der für die erfindungsgemäß angewandte Messtechnik ungünstigeren Strahlungscharakteristik kaum an mehreren Stationen mit Amplituden gemäß einer 1/R-Abhängigkeit zu empfangen sein.

Die vorliegende Erfindung beinhaltet, speziell für linienförmige Impulsquellen, auch die Option einer Trennung von Impulsquellen, zum Beispiel von IC-(bzw. CC-)Blitzen, in vertikale und horizontale Entladungskanäle, insbesondere Blitzkanäle, das heißt die Möglichkeit einer Diskriminierung von IC-(bzw. CC-)Entladungen, insbesondere von IC-(bzw. CC-)Blitzen, die schwerpunktmäßig vertikal oder horizontal verlaufen.

Dies wird erfindungsgemäß dadurch erreicht, dass die an einer ausreichenden Anzahl von Sensorstationen gemessenen Amplituden A hinsichtlich ihre Entfernung R geprüft werden:
ist die entfemungsabhängige Amplitude A(R) mit einem 1/R-Gesetz verträglich und ist das Impulsereignis, insbesondere Blitzereignis, mittels der 3D-Methode als I[ntra]C[loud]- bzw. I[nter]C[loud]-Typ eingestuft werden, dann handelt es sich um einen vorwiegend vertikalen Blitz.

Lassen sich jedoch starke Abweichungen vom 1/R-Gesetz feststellen und lassen sich diese dadurch korrigieren, dass die Strahlungscharakteristik gemäß zweier Winkel, zum Beispiel dem Höhenwinkel und dem Winkel zwischen Impulsabgabe-/aussendungsachse, insbesondre Blitzachse, und Richtung zum Sensor, berücksichtigt wird, dann handelt es sich um einen vorwiegend horizontalen Entladungskanal, insbesondere Blitzkanal.

Die von der Entfernung R abhängigen Amplituden A(R) können durch variable Bodenleitfähigkeit bedämpft sein, was eine 1/R-Abhängigkeit stören kann. In der vorliegenden Erfindung wird diesem Umstand Rechnung getragen, indem Gruppen von Impulsquellen, zum Beispiel von Blitzen, aus engen räumlichen Bereichen gemäß einer bevorzugten Weiterbildung des vorliegenden Systems wie auch des vorliegenden Verfahrens gemeinsam analysiert werden. Mit dieser optionalen technischen Maßnahme lässt sich feststellen, ob bei gleicher oder sehr ähnlicher Laufstrecke die Dämpfungseffekte beständig oder nur bei einzelnen (. horizontalen) Impulsen, insbesondere Blitzen, auftreten.

Diese letztgenannte Gruppenanalyse kann zweckmäßigerweise sogar online erfolgen, wenn beispielsweise das jeweilige Gewitter innerhalb des gewählten Meldezeitraums für dreidimensionale Impulsortungen, insbesondere Blitzortungen, (von zum Beispiel einer Minute) genügend Blitze aus der gleichen Gegend liefert. Ansonsten kann diese Zusatzinformation über horizontale Impulse, insbesondere über horizontale Blitze, auf jeden Fall offline, also bei nachträglicher Analyse, festgestellt werden.

Interessant ist im Zusammenhand mit der vorliegenden Erfindung noch die Frage, inwieweit aufwärts gerichtete Erde-Wolke-Entladungen (G[round-]C[loud]), zum Beispiel Erde-Wolke-Blitze, an der Wolkenuntergrenze ausstrahlen. Insofem ist es nützlich, die erfindungsgemäß erhaltenen Befunde beispielhaft anhand echter 3D-Systeme zu überprüfen [vgl. Defer, E. et al. (2000), "Simultaneous observations of CG activity from NALDN and ONERA-ITF interferometric mapper during the STERAO-A experiment". In: Int. Lightning Detection Conf., Nov. 7-8, Tucson, Arizona (Global Atmospherics Inc.)].

Eine Verfeinerung der vorliegenden Erfindung, also des Pseudo-3D-Systems bzw. des Pseudo-3D-Verfahrens zur Ermittlung von Höhen von Impulsquellen, zum Beispiel von Blitz-Emissionshöhen, Im VLF-Bereich hinsichtlich noch genauerer Zeitauflösungen, als sie in der ersten Phase des Netzes realisiert sind, und die Kombination mit Impulsform-Analysen erlaubt mit minimalem Zusatzaufwand eine zuverlässigere und nahezu quantitative (Online-)Diskriminierung von CG-Impulsen, insbesondere von CG-Blitzen, und IC-Impulsen, insbesondere IC-Blitzen.

Grundsätzlich erlaubt die durch die Lehre gemäß der vorliegenden Erfindung vermittelte Nutzung des 2D-Blitzortungsnetzes als Pseudo-3D-Netz die Identifizierung von Entladungen, die in Gewitterwolken aus großer Höhe emittiert werden.

Bei einer vorteilhaften Ausführungsform der vorliegenden Erfindung misst der Sensor tatsächlich die magnetische Induktion B(t) direkt als Funktion der Zeit. Dabei wird - wie physikalisch zwingend vorgegeben - das Induktionsgesetz genutzt. Die Nutzung des Induktionsgesetzes führt bei konventioneller Anwendung zu einer Messspannung, die der Ableitung dB/dt der magnetischen Induktion B(t) nach der Zeit t proportional ist.

Eine zweckmäßige Ausführungsform der vorliegenden Erfindung beinhaltet jedoch eine elektrotechnische Schaltungsweise, die im gewählten Frequenzbereich tatsächlich zu B(t) führt. Wichtiger Nebeneffekt ist, dass dadurch keine nachfolgenden Elemente zur Integration von dB/dt zu B(t) notwendig sind (falls sie nötig gewesen wären, würden derartige nachfolgende Elemente wiederum zu zusätzlichen Ungenauigkeiten führen, weil auch über die unvermeidbaren Rauschanteile integriert würde). Erfindungsgemäß ist das System auch so ausgelegt, dass gleichzeitig extrem hohe Signalempfindlichkeit entsteht.

Voraussetzung für die Anwendung des Systems wie auch des Verfahrens gemäß der vorliegenden Erfindung ist eine auch bei komplexen Impulsformen, insbesondere Blitz-Impulsformen, auf etwa eine Mikrosekunde genaue Bestimmung der SignalAnkunftszeiten an den einzelnen Sensorstationen, die bei optimaler Nutzung von GPS-Empfängem und bei intelligenter Impulsanalyse erzielbar ist.

Es ist also erfindungsgemäß möglich, einen Großteil der in einem Ortungsnetz peilbaren Impulse, insbesondere Blitze, in Netzen mit geringeren Stationsabständen sogar die Mehrzahl aller Impulse, inbesondere Blitze, einer 3D-Analyse zu unterziehen und sehr direkt - ohne jegliche theoretische Annahme und ohne jeglichen justierbaren Parameter - festzustellen, ob die Emission bodennah erfolgte.

Damit ist ein wesentlicher Beitrag zu einer nachvollziehbar zuverlässigen Identifizierung von CG-Impulsen, insbesondere von CG-Blitzen, auch in räumlich großen Netzen erzielt, ohne nennenswerten Zusatzaufwand zu betreiben. Die Vorteile "echter" 3DSysteme bleiben davon gänzlich unberührt, weil diese grundsätzlichere physikalische Vorgänge sowie kleinräumigere Entladungskanal-Auflösungen, zum Beispiel Blitzkanal-Auflösungen, zum Ziel haben, als dies bei der hier behandelten reinen Blitzortung der Fall ist.

Wie bei der Darstellung der vorliegenden Erfindung eingangs bereits dargelegt, kann das Orten von Impulsquellen, insbesondere die Blitrortung, mittels V[ery]L[ow]F[requency]-Messungen entweder mittels der Methode der Richtungspeilung (sogenanntes "D[irection]F[inding]") und/oder mittels des Laufzeitdifferenzverfahrens (sogenannte *T[ime]O[f]A[rrival] method") erfolgen.

Bei der traditionellen Richtungspeilung (DF = direction finding) wird an den Sensorstationen die Einfallsrichtung der elektromagnetischen Strahlung, insbesondere die Einfallsrichtung des Blitzsignals, gemessen und die Impulsquelle mittels Schnittpunktmethoden lokalisiert, insbesondere der Blitzort bestimmt. Bei dieser konventionellen Methode treten Ungenauigkeiten auf, die als lokaler Fehler oder "site error" bezeichnet werden.

In der Vergangenheit sind Verfahren publiziert worden, um diese Fehler im Nachhinein zu korrigieren und somit die Ortungsgenauigkeit zu erhöhen. Dies geschieht meist dadurch, dass eine Ortung ohne einen bestimmten Sensor erfolgt; damit ergibt sich aus dem Ort der Impulsquelle, insbesondere aus dem Blitzort, und aus dem Sensorort ein Sollwinkel. Dieser Sollwinkel wird mit dem tatsächlich gemessenen Winkel verglichen, und aus der Differenz wird eine Winkelkorrektur abgeleitet. Durch zyklisches Wiederholen des Verfahrens kann eine Optimierung erfolgen. Hierbei können auch (genauere) T[ime]O[f]A[rrival]-Ortsbestimmungen mit herangezogen werden.

Die zu korrigierenden Winkelfehler sind durch Fehler des Antennenaufbaus sowie durch Einwirkungen, wie Reflexionen oder Leitfähigkeitsgradienten der Umgebung, verursacht Die Korrekturverfahren kompensieren den Gesamtfehler, insbesondere wenn nicht eine einzige Winkelkorrektur, sondern eine Korrekturfunktion in Abhängigkeit der Einfallswinkel ermittelt wird.

Beim T[ime]O[f]A[rrival]-Verfahren sind ebenfalls die beiden vorgenannten Fehler entsprechend möglich, nämlich
- unterschiedliche Laufzeiten der Signale in der Elektronik der einzelnen Sensorstandorte und/oder
- umgebungsbedingte Zeitverzögerungen, wie sie zum Beispiel durch Unterschiede in der Leitfähigkeit und damit in der SignalAusbreitungsgeschwindigkeit oder durch Reflexionen und Überlagerungen infolge nicht-ebener Geländestrukturen auftreten können.

Bislang sind hierzu keine der D[irection]F[inding]-Korrektur entsprechenden Korrekturverfahren für die T[ime]O[f]A[rrival]-Methode bekannt.

Aufgrund der beschriebenen Problematik soll das System der eingangs genannten Art sowie das Verfahren der eingangs genannten Art so weiterentwickelt werden, dass Fehler bei der Ermittlung des jeweiligen zeitlichen Verlaufs, insbesondere der jeweiligen Ankunftszeit und/oder der jeweiligen Signallaufzeit, der erfassten Signale minimiert werden.

Diese Problemstellung wird durch ein System sowie durch ein Verfahren gelöst, bei dem mindestens eine der Messstationen oder Sensor(station)en justiert und/oder geeicht wird, wobei dieses Justieren und/oder dieses Eichen anstelie des oder ergänzend
- zum Lokalisieren der Höhe, insbesondere der Emissionshöhe bzw. der Sendehöhe, der Impulsquelle und/oder
- zum Bestimmen der Direktionalität, insbesondere des räumlichen Richtungsverlaufs, der Impulsabgabe/-aussendung natürlichen und/oder nichtnatürlichen Ursprungs, insbesondere des Blitzes, der Ladungsabgabe, der Ladungsaussendung oder dergleichen, erfolgt.

Dieses Eichkorrektur- und/oder Justierverfahren kann insbesondere zur Optimierung und/oder zur Korrektur der T[ime]O[f]A[rrival]-Technik eingesetzt werden, denn es bietet einen wesentlichen Vorteil hinsichtlich der Erzielung verbesserter Zeitmarken bzw. Zeitmarkierungen. Mittels dieses Eich- und/oder Justierverfahrens können sowohl 2D-Ortspeilungen als auch 3D-Höhenpeilungen von Blitzentladungen mit verbesserter Genaulgkeit ausgeführt werden.

Bei einer vorteilhaften Ausführungsform wird zunächst die Position, insbesondere der Ort und/oder die Höhe, der Impulsquelle lokalisiert, indem unter Ausschluss der zu justierenden und/oder zu eichenden Messstation aus dem ermittelten jeweiligen zeitlichen Verlauf, insbesondere aus der ermittelten jeweiligen Ankunftszeit, der jeweilige Laufzeitunterschied von Impulsen derselben Impulsquelle zur jeweiligen Messstation ermittelt wird.

Des Weiteren wird der jeweilige zeitliche Verlauf, insbesondere die jeweilige Ankunftszeit, der von der lokalisierten Impulsquelle stammenden und an der zu justierenden und/oder zu eichenden Messstation erfassten Signale berechnet.

Darauf aufbauend wird die Differenz zwischen dem berechneten jeweiligen zeitlichen Verlauf, insbesondere der berechneten jeweiligen Ankunftszeit, und dem ermittelten jeweiligen zeitlichen Verlauf, insbesondere der ermittelten jeweiligen Ankunftzeit, der von der lokalisierten Impulsquelle stammenden und an der zu justierenden und/oder zu eichenden Messstation erfassten Signale ermittelt und in statistisch aussagekräftiger Weise aufbereitet.

Erforderlichenfalls wird schließlich aufgrund der ermittelten jeweiligen Differenz mindestens ein Zeitkorrekturterm, insbesondere für spätere Lokalisierungen und/oder für spätere Ortungen, ermittelt und die zu justierende und/oder zu eichende Messstation mittels dieses ermittelten Zeitkorrekturterms justiert und/oder geeicht.

Das vorliegende Justier- und/oder Eichverfahren basiert in erfindungswesentlicher Weise darauf, dass die Signalanalyse in der Zentralstation die Erfassung der Verteilung von Zeitabweichungen zwischen gemessener Signal-Ankunftszeit und aufgrund der erfolgten Peilung elektromagnetischer Strahlung, insbesondere der erfolgten Blitzpellung, errechneter Ankunftszeit in statistisch aussagekräftiger Weise aufbereitet, um aus der Form der ermittelten Verteilung die ordnungsgemäße technische Zeitbehandlung der Signallaufzeiten zu prüfen und gegebenenfalls nachzujustieren. Nach Ausführung dieses Prüf- und Justierverfahrens ist eine optimale Nutzung der Laufzeitunterschiede zur Höhenpeilung gewährleistet.

Die vorliegende Erfindung betrifft schließlich die Verwendung mindestens eines Systems gemäß der vorstehend dargelegten Art und/oder eines Verfahrens gemäß der vorstehend dargelegten Art zur Lokalisierung
- der Höhe der Impulsquelle, insbesondere der Emissionshöhe bzw. der Sendehöhe, und/oder
- der Direktionalität, insbesondere des räumlichen Richtungsverlaufs, der durch die Impulsquelle bewirkten Impulsabgabe oder Impulsaussendung;
insbesondere kann die vorliegende Erfindung bei der genauen sowie zuverlässigen Abgrenzung von Impulsabgaben oder Impulsaussendungen, zum Beispiel von Entladungen, Innerhalb einer Gewitterwolke (sogenannte I[ntra]C[loud]-Blitze) und/oder zwischen mindestens zwei Gewitterwolken (sogenannte C[loud-]C|loud]-Blitze), gegenüber Impulsabgaben oder Impulsaussendungen, zum Beispiel Entladungen, zwischen Wolke und Erde (sogenannte C[loud-]G[round]-Blitze) eingesetzt werden, was wiederum eine im Vergleich zum Stand der Technik zuverlässige Erstellung von Impulsdichtekarten, zum Beispiel von Blitzdichtekarten, ermöglicht.

Das System gemäß der vorstehend dargelegten Art und/oder das Verfahren gemäß der vorstehend dargelegten Art kann zur Eichung und/oder zur Justierung mindestens einer Mess- oder Sensorstation in Netzwerken zur Blitzortung eingesetzt werden.

Unabhängig hiervon oder in Verbindung hiermit kann die vorilegende Erfindung, das heißt das System gemäß der vorstehend dargelegte Art und/oder das Verfahren gemäß der vorstehend dargelegten Art im Echtzeit- oder Kurzfristbereich
- zur Vorhersage und zur Lokalisation, insbesondere zur Früherkennung, von klimatologischen und/oder meteorologischen Vorgängen, wie etwa von Blitzschlag, von (Extrem-)Niederschlag, von Gewittern, von Hagel, von Orkanen, von (Stark-)Regen, von Sturm, von Unwettem, von Wind oder von anderen besonderen klimatologischen und/oder meteorologischen Ereignissen,
- zur dreidimensionalen Ortung von Impulsquellen, zum Beispiel von Blitzen, unter Einbeziehung schwacher Signale zum Optimieren der Vorhersage und Lokalisation, insbesondere der Früherkennung, von Gewitterzellen,
- zur Erkennung von Signalherden zur Vorhersage und Lokalisation, insbesondere zur Früherkennung, von Gewitterzellen,
- zur Analyse von Gruppen der Daten und Informationen zur Charakterisierung meteorologischer Klassen,
- zur Extrapolation von räumlichen Zugbahnen erkannter Gewitterherde und/oder
- zur Gewinnung biometeorologischer informationen
verwendet werden.

### Kurze Beschreibung der Zeichnungen

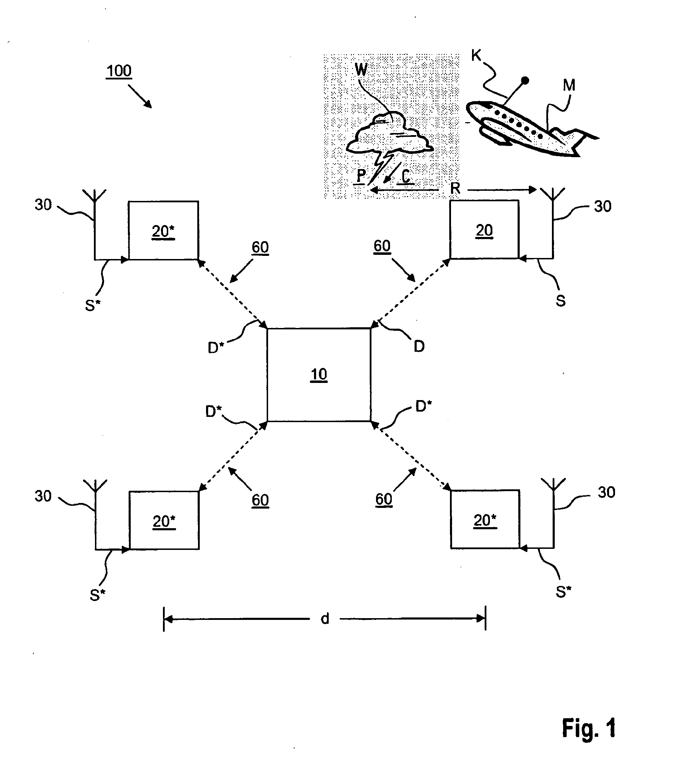

Wie bereits vorstehend erörtert, gibt es verschiedene Möglichkeiten, die Lehre der vorliegenden Erfindung in vorteilhafter Weise auszugestalten und weiterzubilden. Hierzu wird einerseits auf die den Ansprüchen 1 und 10 nachgeordneten Ansprüche verwiesen, andererseits werden weitere Ausgestaltungen, Merkmale und Vorteile der vorliegenden Erfindung nachstehend anhand des durch die Figuren 1 bis 8D veranschaulichten Ausführungsbeispiels näher erläutert.

Es zeigt
- Fig. 1: in schematischer Darstellung ein Ausführungsbeispiel eines Systems gemäß der vorliegenden Erfindung, das nach dem Verfahren gemäß der vorliegenden Erfindung arbeitet;
- Fig. 2A: in schematischer Darstellung ein Ausführungsbeispiel einer Messstation des Systems aus Fig. 1;
- Fig. 2B: in perspektivischer Darstellung ein Ausführungsbeispiel einer Antenneneinheit, die der Messstation aus Fig. 2A zugeordnet ist;
- Fig. 3: in schematischer Darstellung ein Ausführungsbeispiel einer Zentralstation des Systems aus Fig. 1;
- Fig. 4: in topographischer Darstellung ein Ausführungsbeispiel einer geographischen Verteilung der Messstationen und der Zentralstation des Systems aus Fig. 1;
- Fig. 5: in schematischer Darstellung das Prinzip des Verfahrens gemäß der vorliegenden Erfindung, wobei H die Emissonshöhe der V[ery]L[ow]F[requency]Blitzstrahlung ist;
- Fig. 6: in diagrammatischer Darstellung die innerhalb eines auf der Rechtsachse aufgetragenen Längengradbereichs sowie innerhalb eines auf der Hochachse aufgetragenen Breitengradbereichs erfolgenden Signale von nach dem Verfahren gemäß der vorliegenden Erfindung ausgewerteten atmosphärischen Entladungen;
- Fig. 7A: in diagrammatischer Darstellung die nach dem Verfahren gemäß der vorliegenden Erfindung ermittelte, auf der Hochachse aufgetragene zeitliche Verzögerung der Signal-Ankunftszeiten als Funktion der auf der Rechtsachse aufgetragenen Beobachtungsdistanz für verschiedene Emissionshöhen;
- Fig. 7B: in diagrammatischer Darstellung ein erstes Beispiel für eine nach dem Verfahren gemäß der vorliegenden Erfindung ermittelte Entladungs-Höhenverteilung (= auf der Rechtsachse vermerkt Anzahl der Entladungen, aufgetragen gegen die auf der Hochachse vermerkte, in Kilometem gemessene Emissionshöhe);
- Fig. 7C: in diagrammatischer Darstellung ein zweites Beispiel für eine nach dem Verfahren gemäß der vorliegenden Erfindung ermittelte Entladungs-Höhenverteilung (= auf der Rechtsachse vermerkte Anzahl der Entladungen, aufgetragen gegen die auf der Hochachse vermerkte, in Kilometem gemessene Emissionshöhe);
- Fig. 7D: in diagrammatischer Darstellung ein drittes Beispiel für eine nach dem Verfahren gemäß der vorliegenden Erfindung ermittelte Entladungs-Höhenverteilung (= auf der Rechtsachse vermerkte Anzahl der Entladungen, aufgetragen gegen die auf der Hochachse vermerkte, in Kilometem gemessene Emissionshöhe); und
- Fig. 8: in diagrammatischer Darstellung die auf der Hochachse aufgetragene Verteilung (= Anzahl) der nach dem Verfahren gemäß der vorliegenden Erfindung ermittelten, auf der Rechtsachse aufgetragenen Zeitabweichungen (in us oder Mikrosekunden) der Ankunftssignale (negative Zeiten bedeuten Zeitverzögerung).

Gleicht oder ähnliche Ausgestaltungen, Elemente oder Merkmale sind in den Figuren 1 bis 8 mit identischen Bezugszeichen versehen.

### Bester Weg zur Ausführung der Erfindung

In Figur 1 ist ein System 100 dargestellt, das
- sowohl zur Charakterisierung von nichtnatürlicher Strahlung, zum Beispiel
- von mittels eines Senders K eines Flugzeugs M gesendeten Signalen oder
- von Mobilfunksignalen,
- als auch zur Charakterisierung von natürlicher Strahlung, zum Beispiel von Blitzentladungen P,
eingesetzt werden kann.

Da die der Messung derartiger Impulsabgaben bzw. Ladungsaussendungen (Ladungsabgaben) zugrunde liegenden Verfahrensprinzipien für die aus Impulsquellen nichtnatürlichen Ursprungs stammende elektromagnetische Strahlung und für die aus Impulsquellen natürlichen Ursprungs stammende elektromagnetische Strahlung gleich bzw. zumindest analog sind, wird das System 100 Im Folgenden beispielhaft beim Einsatz in der Blitzmessung beschrieben.

Das anhand der Figuren 1 bis 8 veranschaulichte, im speziellen als Sferics-/Blitzmessungsanordnung ausgebildete (= gewissermaßen dreidimensionales Blitzortungsnetzwerk 100) System weist mehrere, nämlich bis zu einhundert Einzel-Messstationen 20, 20* (in Figur 1 sind exemplarisch vier derartige Messstationen 20, 20* dargestellt) sowie eine Zentraleinrichtung oder Zentralstation 10 auf.

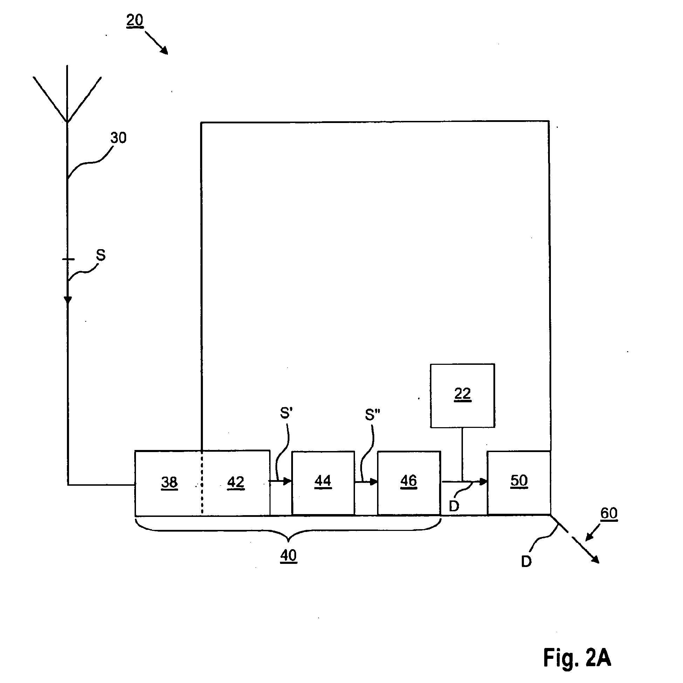

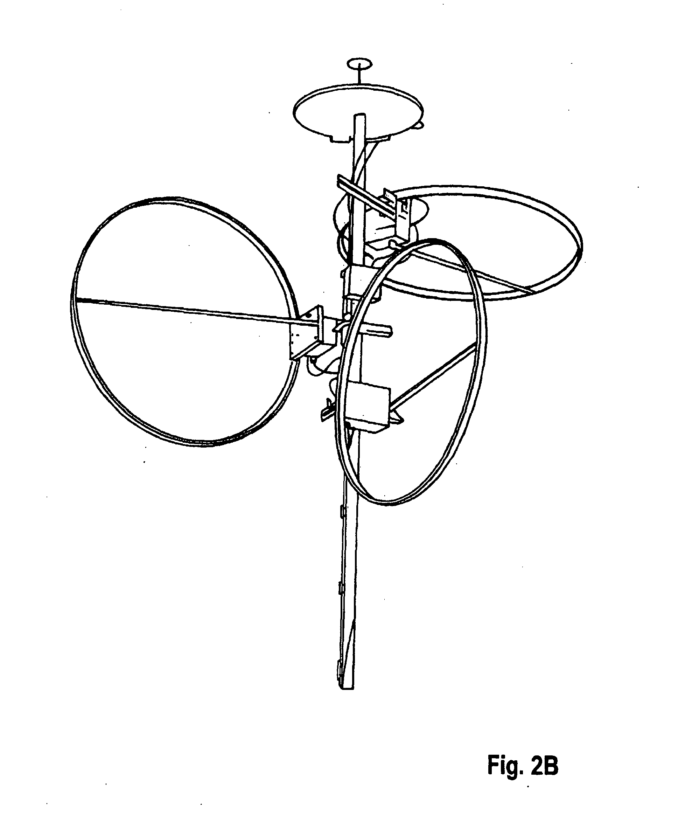

Wie der Darstellung der Figuren 1 und 2A entnehmbar ist, ist jeder Messstation 20, 20* eine Antenne bzw. ein Antennenkörper 30 (vgl. Figur 2B) zugeordnet, der für die Messung niederfrequenter magnetischer Felder ausgelegt ist.

Hierbei ist aus Figur 2B ersichtlich, dass dieser Antennenkörper 30 in mechanisch selbsttragender Form ohne bewegliche und/oder witterungssensitive Komponenten zum Aufstellen im Freien ausgelegt ist. Der Primärkreis des Antennenkörpers 30 ist vom Sekundärkreis des Antennenkörpers 30 galvanisch getrennt; die elektromagnetischen Felder sind breithandig und rauscharm auskoppelbar und damit zeitgetreu messbar.

Die im Gehäuse der Messstation 20 bzw. 20* angeordnete Stationselektronik 40 weist zunächst einen Verstärker 42 zur rauscharmen Verstärkung der vom Antennenkörper 30 kommenden Signale S bzw. S* auf. Dem Verstärker 42 nachgeschaltet ist eine Filterstufe 44. Das mittels der Filtereinheit 44 gefilterte Signal S* wird sodann In der Einheit 46 einer Signaldigitalisierung unterzogen.

Mittels des rauscharmen Verstärkers 42 und der Filterstufe 44 kann ein Glättungs- und Optimierungsverfahren der Signale S bzw. S* durchgeführt werden, was aufgrund der im Folgenden dargestellten Problematik einen wesentlichen Vorteil darstellt.

Bei Signalen mit großer Amplitude und mit einfacher, ungestörter Form ist die Ermittlung einer charakteristischen Ankunftszeit relativ leicht zu bewerkstelligen. Konventionelle Systeme gemäß dem Stand der Technik beziehen sich In ihrer Anwendung - im Unterschied zur vorliegenden Erfindung - lediglich auf solche Fälle glatter Kurvenformen und suchen nur das Maximum des jeweiligen Signals.

Die in der Praxis an den Sensoren 20 bzw. 20* eintreffenden Signale S bzw. S* sind jedoch meistens
- klein,
- mit eigenen, oft komplexen und unregelmäßigen Strukturen behaftet und
- von Rauschanteilen überlagert.
Damit wird es schwieriger, eine klare Zeitmarkierung zu erhalten, insbesondere wenn das Signal S bzw. S* schwach ist und nahe der unteren Nachweisschwelle liegt.

Insbesondere führt dann das Suchen nach dem (einzigen) absoluten Signalmaximum bei verschiedenen Sensoren konventionellerweise zu Ungenauigkeiten, die unabhängig von der Nutzung genauesber Zeitnormale, wie zum Beispiel der G[lobal]P[ositioning]S[ystem]-Methode, meist deutlich über einer Mikrosekunde liegen. In nicht seitenen Fällen führt die Schwierigkeit bzw. Ungenauigkeit einer herkömmlichen Maximumsfindung letztlich zur Verwerfung des gesamten Signals.

Zur Eliminierung der vorgenannten Probleme werden beim System 100 gemäß Figur 1 in Verbindung mit Figur 2A die Signalamplituden, die vorwiegend, aber nicht ausschließlich um ein Maximum herum liegen, einem Glättungs- und Optimierungsverfahren unterzogen, mit dem sich Unregelmäßigkeiten im Signalverlauf ausgleichen lassen.

Die entsprechenden Algorithmen basieren im Wesentlichen auf Standardverfahren, sind jedoch
- in der Art der Anwendung auf die speziellen Verhältnisse des Systems 100 adaptiert und
- mathematisch auf kurze Rechenzeit optimiert.
Damit wird es möglich, auch schwache, unregelmäßige und verrauschte Signale noch mit ausreichender Zeitgenaulgkeit zu markieren.

Des Weiteren wird beim System 100 gemäß Figur 1 in Verbindung mit Figur 2A nicht nur der größte Peak eines Signals S bzw. S* dem vorstehend dargelegten Glättungs- und Optimierungsverfahren unterzogen; vielmehr wird die gesamte oberhalb der Rauschschwelle liegende Signalstruktur gemäß diesem Glättungs- und Optimierungsverfahren analysiert. Somit können zu jedem einzeinen Signal S bzw. S* in Abhängigkeit von der tatsächlich vorliegenden Gesamtimpulsform eine Mehrzahl an Zeit- bzw. Strukturinformationen zur Verfügung stehen.

Im Hinblick auf die Stationselektronik 40 ist zu bemerken, dass zwischen der Digitalisierungseinheit 46 und einer zum Speichem der von der Stationselektronik 40 verarbeiteten Daten und informationen D bzw. D* vorgesehenen Speichereinheit 50 ein P[ersonal]C[omputer] 22 geschaltet ist. In der zentralen Auswertesoftware des P[ersonal]C[omputer]s 22 werden die nach dem beschriebenen Glättungs- und Optimierungsverfahren ermittelten Strukturen der Zeitinformationen miteinander abgeglichen.

In diesem Zusammenhang ist zu bedenken, dass konventionellerweise für das Sensorsignal nur eine Zeitmarke zur Verfügung steht, so dass im Stand der Technik eine (ungewollte) Einbeziehung von zeitgleichen Störsignalen auftreten kann.

Zur Vermeidung diese Nachteils sind die Analyseeigenschaften der zentralen Auswertung im Hinblick auf das Glättungs- und Optimierungsverfahren so ausgelegt, dass die gegebenenfalls vorhandenen Mehrfachinformationen in Form von Zeitstrukturen bei den einzelnen Sensorsignalen, das heißt innerhalb einer zum gleichen Blitz gehörenden Signalgruppe, aufgrund der genauen Zeiterfassung und -markierung miteinander hinreichend verträglich sind.

Durch den systemgemäß bevorzugten Einsatz mehrfacher Zeitmarken und/oder mehrfacher Zeitstrukturen wird
- die Genauigkeit der Signalzeit-Markierung erhöht und
- die Wahrscheinlichkeit eines (unerwünschten) Einbezugs eines Störsignals, zum Beispiel technischen Ursprungs mit anderen Zeitstrukturen, erheblich verringert,
so dass die sich enschließende Analyse zu keiner Fehlpeilung führt.

Ausgehend von der Speicheranordnung 50 kann schließlich über eine grundsätzlich bidirektional ausgestaltete Verbindung 60 eine Übertragung ausgewählter Parameter der Signale S bzw. S* an die Zentralstation 10 vorgenommen werden.

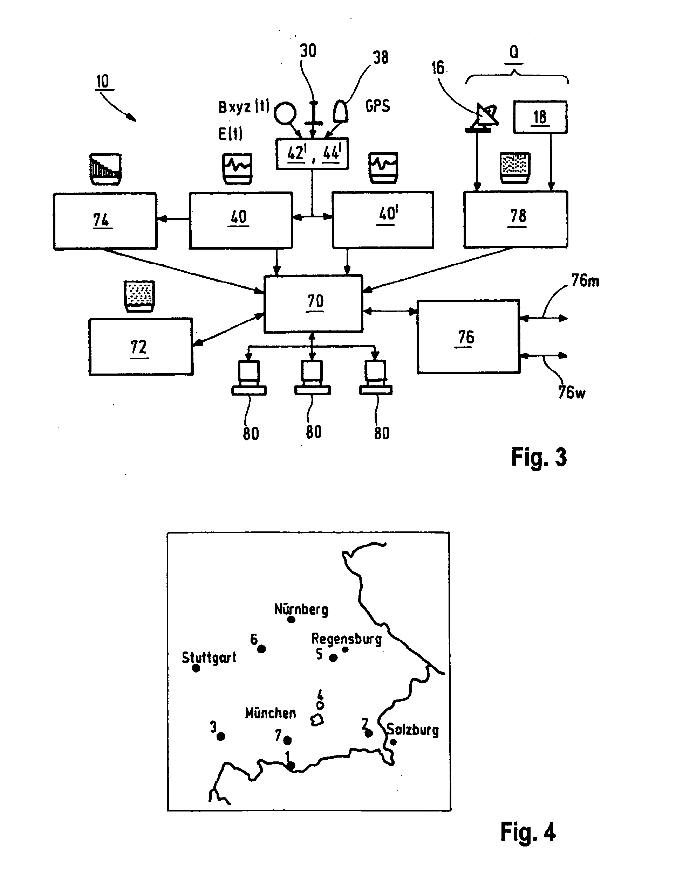

In Figur 3 ist der Aufbau der Zentralstation 10 dargestellt. Die Sferics-Online-Aufzeichnung erfolgt in verschiedenen Amplituden- und Zeitbereichen an zwei getrennten Aufzeichnungssystemen 40, 40'. Beiden Aufzeichnungssystemen 40, 40' steht eine hochgenaue G[lobal]P[ositioning]S[ystem]-Zeitbasis 38 mit einer Genauigkeit von etwa dreihundert Nanosekunden zur Verfügung. Allen anderen Einzelkomponenten des lokalen Stationsnetzes wird die GPS-Zeit über einen zentralen Datenserver 70 zur Verfügung gestellt.

Das als Stationselektronik ausgebildete erste Aufreichnungssystem 40 (vgl. hierzu auch Figur 2A) dient der Erfassung von sogenannten Standard-Sferics und ist Bestandteil nicht nur der Zentralstation 10, sondem auch aller Messstationen 20 bzw. 20*. Die Aufzeichnung der Feldamplituden erfolgt hier jeweils für ein Zeitintervall von 512 Mikrosekunden in einem Amplitudenbereich der magnetischen Feldstärke bis sechs Nanotesla.

Ist die spezifische Triggerbedingung für eine Komponente des Signals S bzw. S* erfüllt, wird die GPS-Ereigniszeit in einem Hardwareregister eingefroren. Nach Beendigung der Digitalisierung wird aus dem Verhältnis der zeitabhängigen Magnetfeld-Verläufe der magnetische Feldvektor berechnet und dessen zeitabhängiger Betrag, das heißt die aktuelle Sferics-Lage, auf einem Bildschirm oder Monibor 72 dargestellt.

Mit einer Unsicherheit von 180 Grad gibt der magnetische Feldvektor die Einfallsrichtung des Signals S bzw. S* an. Steht auch der zeitliche Verlauf der elektrischen Feldamplitude zur Verfügung, kann die Einfallsrichtung retativ genau bestimmt werden. Diese Einfallsrichtung wird zusammen mit dem Triggerzeitpunkt und dem zeitlichen Verlauf des Magnetfeldbetrags auf dem zentralen Datenserver 70 abgelegt. Zusätzlich erfolgt eine F[ast]F[ourier]T[ransformation] 74 des Signals S bzw. S* mit Online-Darstellung.

Für Belange der Blitzforschung anhand von Messanordnungen im V[ery]L[ow]F[requency]-Bereich (sogenannte angewandte Sferics-Forschung) ist an der Zentralstation 10 ein zweites Aufzeichnungssystem 40' installiert, das Amplituden jeweils
- für ein Zeitintervall von 512 Mikrosekunden sowie
- für ein Zeitintervall von 655 Millisekunden
in einem Feklstärkebereich bis sechzig Nanotesla aufzeichnet.

Mit diesem zweiten Aufzeichnungssystem 40' lassen sich mithin sowohl die jeweils ersten Ereignisse einer möglichen Folge von Teilblitzen über einen Zeitraum von 512 Mikrosekunden als auch die gesamte zeitliche Struktur von Teilimpulsen innerhalb eines Blitzes P erfassen. Die Aufzeichnung der starken, aus dem Nahbereich stammenden Signale S bzw. S* erfolgt daher gleichzeitig in zwei verschiedenen Zeitfenstem mit unterschiedlicher zeitlicher Auflösung:
Neben dem Standard-Zeitfenster von 512 Mikrosekunden (vgl. erste Aufzeichnungseinhet 40), das im Allegemeinen das vom ersten Teilblitz (= sogenannter "First Retum Stroke") erzeugte Signal S bzw. S* in hoher Auflösung aufzeichnet, wird die zeitliche Abfolge der einzelnen Strokes in einem 655 Millisekunden langen Zeitfenster erfasst (zeitliche Stützstellen von sechzehn Kilobit).

Die Empfindlichkeit kann wegen der im Allgemeinen starken Signale S bzw. S* reduziert werden, so dass sich bei der zweiten Aufzeichnungseinheit 40' ein Messbereich bis etwa sechzig Nanotesla ergibt. Der Triggerzeitpunkt, die Einfallsrichtung sowie beide digitalisierten Signalverläufe werden wiederum zentral auf dem Server 70 gespeichert.

Das zweite Aufzeichnungssystem 40' an der Zentralstation 10 erlaubt es also, Ereignisse in zwei verschiedenen Zeitfenstem mit unterschiedlicher Auflösung zu beobachten. Damit können sowohl die zeitliche Abfolge der Strokes innerhalb eines Blitzereignisses als auch hochaufgelöst die von einzelnen Strokes verursachten Sferics aufgezeichnet werden.

Mittels der Kommunikationseinheit 76 können sämtliche benötigten Daten und Informationen D bzw. D* von den externen Messstationen 20 bzw. 20* abgerufen und auf dem zentralen Server 70 abgelegt werden. Für bestimmte Standard-Daten geschieht dies vollautomatisch zu festgelegten Zeitpunkten; spezielle Datensätze können manuell übertragen werden.

Zudem werden mittels der Kommunikationseinheit 76 auch Datenanforderungen von außen bedient; hierfür stehen ein f[ile]t[ransfer]p[rotocol]-Server sowie eine Mailbox zur Verfügung. Alle Messstationen 20 bzw. 20* sind über Modem 76m und Wählleitung 76w an die zentrale Station 10 angebunden.

Um die gewonnenen Sferics-Daten auf Korrelationen mit metereogischen Parametem hin untersuchen zu können, sind Wetter-Informationen Q erforderlich. Hierfür stehen im Wesentlichen zwei Quellen zur Verfügung, nämlich
- ein Meteosat-Empfanger 16, der stets die aktuellen Satellitenbilder anzeigt und archiviert, sowie
- die Mailbox 18 eines Wetterdienstes, die per Wähllekung den Zugriff auf Bodenwetterkarten, auf Radarwetterkarten oder auf dergleichen ermöglicht.

Mittels eines Bildschirms oder Monitors werden somit Satellitenbilder, die Bodenwetterkarten, die Padarwetterkarten und dergleichen online dargestellt (= Bezugszeichen 78 in Figur 3). Wie schließlich der Darstellung gemäß Figur 3 entnehmbar ist, sind (in Figur 3 exemplarischerweise drei) Arbeitsplätze 80 zur Datenanalyse an den zentralen Server 70 [= File Server, GPS Time Server (Netware Server)] angeschlossen.

Die erfindungswesentlichen Funktionen der Zentralstation 10 bestehen darin
- die von den jeweiligen Messstationen 20 bzw. 20* übermittelten Daten und Informationen D bzw. D*, insbesondere auch in hohen Raten und/oder insbesondere auch ohne zeitlichen Verlust auszuwerten und
- abgestufte und/oder vollautomatische Warnungen vor klimatologischen und/oder meteorologischen Vorgängen, insbesondere vor Gewittern, abzuheben.

Bei dem erfindungsgemäßen Blitzortungssystem 100 ist es gelungen, sämtliche wesentlichen Komponenten besonders effizient zu gestalten, wobei auf Einfachhelt und Kostenminimierung Wert gelegt wird. Die wesentlichen Eigenschaften seien kurz aufgeführt:
Die Sensoren für die V[ery]L[ow]F[requency]-Strahlung von Blitzen sind zwei einfache, gekreuzt angeordnete Spulen, mit denen infolge geeigneter Systemdimensionierung der magnetische Fluss B(t) aus den beiden Komponenten Bₓ(t) und B_{y}(t) des Blitzfeldes gemessen wird (vgl. Figur 2B).

Eine hinreichend getreue Abbildung des zeitlichen Verlaufs der eintreffenden Impulse ist im Bereich von knapp zehn Kilohertz bis etwa vierhundert Kilohertz gegeben. Aus dem Verhältnis der magnetischen Feldkomponenten Bₓ und B_{y} lässt sich die Einfallsrichtung der Blitzstrahlung ermitteln. Der VLF-Sensor arbeitet passiv und benötigt keine Stromversorgung.

Zur Zeitmarkierung wird ein handelsüblicher, separat montierter G[lobal]P[ositioning]S[ystem]-Empfänger verwendet, mit dem die Signal-Ankunftszeit auf etwa eine Mikrosekunde genau festgelegt werden kann; diese Genaulgkeit ist für die Funktionsehigkeit und für die Effeienz der Peilungen von Bedeutung.

Die Sensordaten laufen in einen handelsüblichen P[ersonal]C[omputer] mit speziell entwickelter Modulkarte zur Digitalisierung und Vorverarbeitung.

Die Abtastrate zur Signaldigitalisierung ist auf ein Megahertz eingestellt. Einlaufende Signale werden kontinuierlich erfasst und parallel analysiert, so dass auch bei extrem hohen Raten kein Verlust entsteht. Die maximale Verarbeitungsrate liegt bei über tausend Signalen pro Sekunde.

Durch kontinuierliches Abtasten und Nutzen eines parallelen Verarbeitungskreises misst der Sensor 20, 20* ohne Totzeit. Hierdurch kann der Sensor 20, 20* deutlich höhere Datenraten verarbeiten, als dies in konventionellen Systemen gemäß dem Stand der Technik der Fall ist. Bei konventionellen Systemen kann nach einer Signalerkennung für eine bestimmte (Verarbeitungs-)Zeit nicht auf weitere Signale reagiert werden, weshalb bei hohen Signalraten Datenverlust eintritt.

Da das System 100 gemäß der vorliegende Erfindung im Vergleich zum Stand der Technik deutlich höhere Datenraten verarbeiten kann, sind zwei Folgeeigenschaften möglich:
- Signale können zeitlich früher gemessen werden, wodurch eine zuverlässige Gewitter-Frühwamung ermöglicht wird; und
- die Form von Gewilterzellen wird wesentlich besser sichtbar, weil aufgrund der hohen Empfindlichkeit um etwa eine Größenordnung (= um etwa Faktor zehn) mehr Signale erfasst werden als in Systemen gemäß dem Stand der Technik. Damit werden die Zellenkonturen besser sichtbar, und eine neuartige meteorologische Nutzung der Daten wird ermöglicht. Insbesondere eignen sich diese Daten wegen ihrer großen Anzahl zur Einspeisung in andere meteorologische Anwendungen, wie zum Beispiel für eine Veredlung und Vorhersagenutzung mittels der M[odel]O[utput]S[tatistics]-Technik.

Zu jedem Signal wird ein kompaktes Datenpaket gebildet und per Telefonleitung an eine Zentrale übertragen; aufgrund der D[aten]F[ern]Ü[bertragung]-Bandbreite lassen sich nur etwa einhundert Signale pro Sekunde tatsächlich übertragen, was sich jedoch auch bei stärksten Gewittern als ausreichend erweist, so dass Bufferfunktionen nur selten benötigt werden.

Die gesamten digitalisierten Impulse Bₓ(t) und B_{y}(t) werden an jeder Station archiviert und in aktivitätsarmen Zeiten, das heißt meist nachts abgerufen, um zu Forschungs- und Entwicklungszwecken nutzbar zu sein.

Die Sensoren 20, 20* (vgl. Figur 2A) sind an zum Beispiel sechs Standorten in Süddeutschland (vgl Figur 4) in einem mittleren Abstand von etwa 115 Kilometern montiert, laufen im Dauerbetrieb und senden Daten zur Zentrale 10 (vgl. Figur 3).

Der Zentralrechner ist ebenfalls ein üblicher P[ersonal]C[omputer], der mit Software zur Datenorganisation und zur Blitzpeilung ausgerüstet und für den kontinuierlichen Betrieb ausgelegt ist Auch größere Netze lassen sich aufgrund der effizient gestalteten Betriebsmodi und Softwarelösungen erfindungsgemäß mit einem geeignet ausgestatteten P[ersonal]C[omputer] betreiben, so dass für die Anwendung der vorliegenden Erfindung keine neuen und/oder aufwändigen Zusatzmaßnahmen erforderlich sind.

Auf der Basis des anhand Figur 5 veranschaulichten Prinzips der vorilegenden Erfindung, wonach
- die Emissionshöhe H und/oder
- die Direktionalität C, das heißt der räumliche Rictungsverlauf
einer Blitzentladung P lokalisiert werden kann, wenn die Abweichung der Ankunftszeit des Signals S an der der Blitzentiadung P nächstgelegenen Messstation 20 von der Ankunftszeit des entsprechenden Signals S* an zum Beispiel drei der gleichen Blitzentladung P nicht nächstgelegenen Messstationen 20* bestimmt werden kann (vgl. Figur 1), sind als praktisches Beispiel gemessene Blitze im Überwachungsgebiet mit Längen von 9,5 Grad bis 13,3 Grad und mit Breiten von 47 Grad bis 49,8 Grad in Figur 6 dargestellt.

Es handelt sich um etwas über 14.000 Blitze einschließlich Teilblitzen, die an mindestens drei Sensoren 20, 20* erfasst wurden. Pellungen mit nur zwei Sensoren 20, 20* sind nicht enthalten und würden die Gesamtzahl an Ereignissen noch steigern: die Einbeziehung dieser Daten erfordert jedoch aus Gründen der Vermeidung von Fehlpeilungen vorher eine Korrektur der Peilrichtungen hinsichtlich der sogenannten "site-error", die erst nach einer Gesamtauswertung von Saisondaben erfolgen kann.

Die in den Figuren 6 bis 8 vorgestellten Daten des Netzes 100 gemäß der vorliegenden Erfindung sind in sich konsistent gepeilt und zeigen eine ersichtlich meteorologisch sinnvolie Struktur. Es erhebt sich nun die Frage, wie die Aufteilung in C[loud]G[round]-Blitze und in I[ntra]C[loud]-Blitze zu bewerkstelligen ist.

Die zur Diskriminierung von CG- und IC-Blitzen vorliegende Literatur ist widersprüchlich und soll hier nicht vertieft werden. Diese Frage kann jedenfalls noch als offen betrachtet werden, wobei von noch andauernden Impulsform-Analysen mit verbesserter Zeitauflösung mehr Klarheit erwartet werden kann.

Demzufolge wird das 2D-Netz gemäß der Lehre der vorliegenden Efindung erweitert, nämlich in Form der Nutzung dieses 2D-Netzes als Pseudo-3D-Netz, wodurch eine präzise Erfassung der Signalzeiten, insbesondere der Signallaufzeiten, an den einzelnen Sensorstationen 20, 20* realisiert wird.

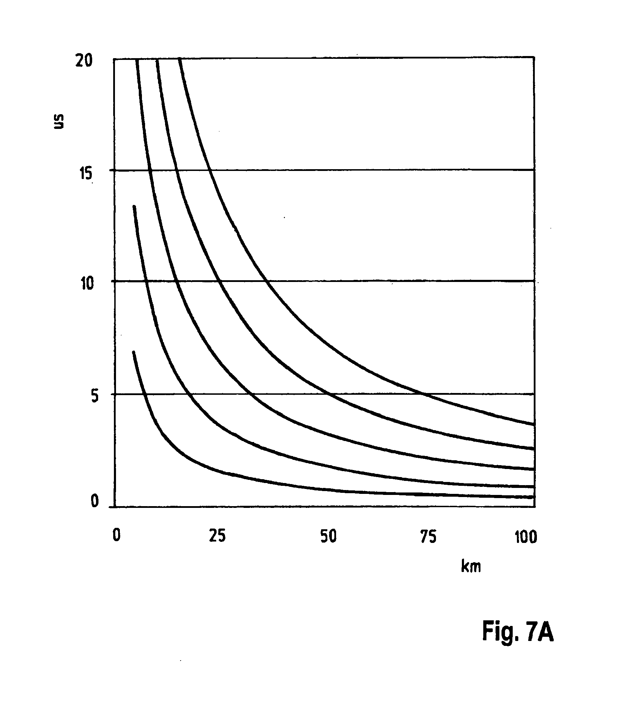

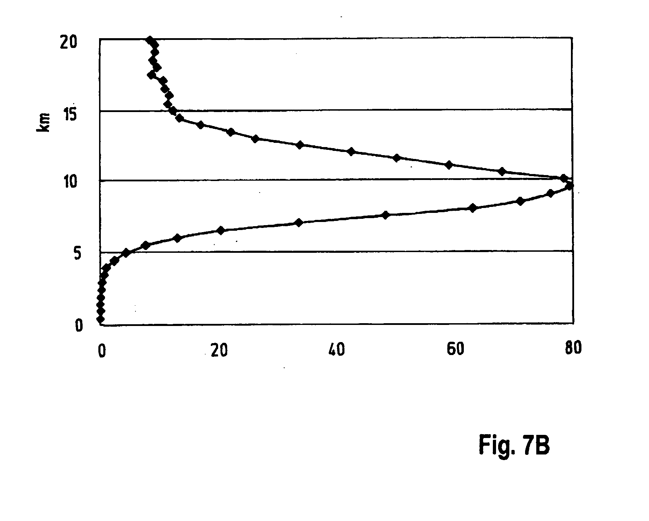

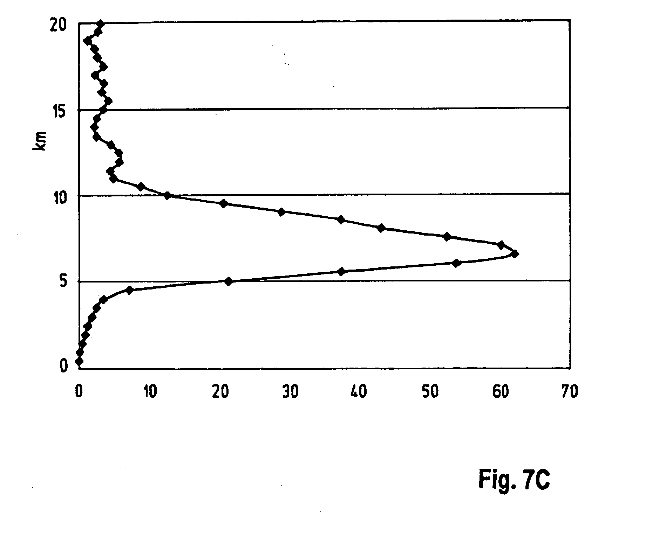

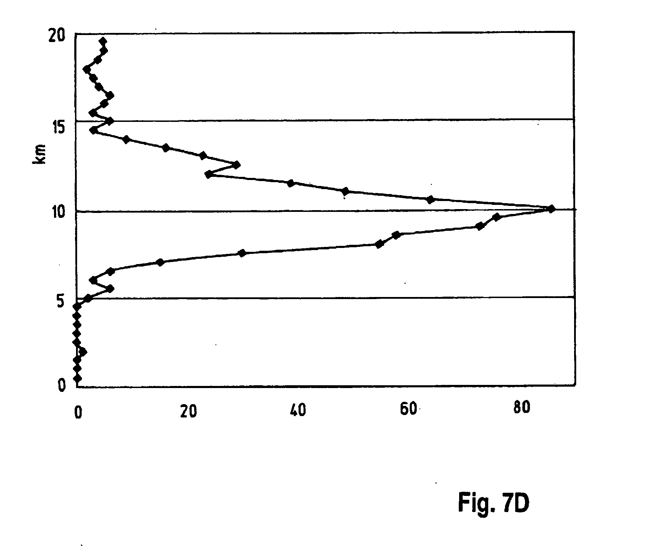

Auf diese Weise eröffnet sich die Möglichkeit, dreidimensionale Peilungen bei hinreichend stationsnahen Blitzen auszuführen. Das Schema zeigt Figur 7A, während die Figuren 7B, 7C und 7D die entsprechende Sensitivität für Höhenpellungen dartegen:
So ist in Figur 7A die erwartete Verzögerung der Ankunftszeiten der Signale S, S* (in Mikrosekunden: us = µsec) als Funktion der (Beobachtungs-) Distanz (in Kilometern) für verschiedene Emissionshöhen H dargestellt, nämlich
   - für eine Emissionshöhe H von fünf Kilometern (= unterste Kurve),
   - für eine Emissionshöhe H von 7,5 Kilometern (= zweitunterste Kurve),
   - für eine Emissionshöhe H von zehn Kilometern (= mittlere Kurve),
   - für eine Emissionshöhe H von 12,5 Kilometern (= zweitoberste Kurve) und
   - für eine Emissionshöhe H von fünfzehn Kilometern (= oberste Kurve).

Figur 7B zeigt die Verteilung (= auf der Rechtsachse aufgetragene Anzahl) der auf der Hochachse aufgetragenen, in Kilometern gemessenen Emissionshöhen H von 951 Blitzen, die in einem Umkreis von bis zu etwa sechzig Kilometern um drei Messstationen gepeilt werden. Es zeigt sich ein Emissionsmaximum in einer Höhe H von knapp unterhalb zehn Kilometem.

Hierbei haben mindestens drei weitere Messstationen die Blitze erfasst. Insgesamt wurden im gleichen Zeitraum 6.929 Blitze an vier oder mehr Messstationen gepeilt; hinzu kommen etwa 7.800 Peilungen mit drei Messstationen, die nur unter zusätzlicher Verwendung von Peilrichtungen 3D-Peilungen erlauben.

In den Figuren 7C und 7D ist jeweils eine entsprechende Blitz-Höhenverteilung, das heißt eine Verteilung der Emissionshöhe H von dreidimensional gepeitten Blitzen während eines Gewitters zu anderen Zeitpunkten als in Figur 7B gezeigt Es ergibt sich ein Emissionsmaximum
- In einer Höhe H zwischen sechs und sieben Kilometern (vgl. Figur 7C) bzw.
- in einer Höhe H von etwa zehn Kilometern (vgl. Figur 7D).
Die dargestellten Daten enthalten keine Bodenblitze.

Gemäß der vorliegenden Erfindung ist bei einer unterstellten Zeitauflösung der Blitz-Ankunftszelten von etwa einer Mikrosekunde eine Höhenpeilung zumindest Im Entfemungsbereich von bis zu etwa hundert Kilometern möglich.

Die Ergebnisse der darauf basierenden Auswertungen sind in den Figuren 7A bis 7D exemplarisch dargestellt. Es erweist sich, dass der Schwerpunkt der V[ery]L[ow]F[requency]-Ausstrahlung von Entladungen in zahlreichen Fällen nicht bodennah, sondern in größerer Höhe innerhalb der Gewitterwolken liegt.

Die Methode gemäß der vorliegenden Erfindung sowie ihre Ergebnisse sollen nun näher hinterfragt werden, um die Relevanz und die Verlässlichkeit besser beurteilen zu können.

Wird das Verfahren anhand eines konkreten Beispiels veranschaulicht, das für die hier vorgestellten Höhenpeilungen typisch ist, so kann ein ungewöhnlich starker Blitz herangezogen werden, dem 251 Millisekunden später eine einzige schwächere Entladung am gleichen Ort folgt.

**Tabelle 1** listet die wesentlichen Daten des Peilverfahrens zu diesern Ereignis auf, nämlich die Pelidaten des Hauptblitzes mit dem um **251** Millisekunden späteren Folgeblitz:

| | Länge | Breite | Typ |
|---|---|---|---|
| Hauptblitz | | | |
| 3D-Peilung | 11,1832 | 47,1962 | CC |
| 2D-Peilung | 11,1889 | 47,1965 | -- |
| | | | |
| Folgeblitz | | | |
| 3D-Peilung | 11,1846 | 47,1974 | CC |
| 2D-Peilung | 11,1909 | 47,1979 | -- |

Die angegebenen Abweichungen gelten relativ zur erstgenannten Peilung; die innere Qualität des mit Daten von sechs Stationen erzielten Peilergebnisses gemäß der vorliegenden Erfindung verbessert sich beim Übergang von der zweldimensionalen Peilung zur dreidimensionalen Peilung ganz erheblich.

Wenn die Blitzortung ohne Berücksichtigung von Emissionshöhen erfolgt, ergibt sich eine von der Qualität her zwar akzeptable Ortung, jedoch ist der Peilfehler höher, als im Mittel zu erwarten wäre.

Eine Inspektion der an allen sechs Stationen des Netzes erfassen Blitzzelten erweist, dass die Ankunftszelt an der betreffenden Station gegenüber der aus dem Gesamtnetz erwarteten Zeit und entgegen den entsprechenden Zeitfehlem der anderen fünf Stationen atypisch um knapp sieben Mikrosekunden verzögert ist.

Wind nun erfindungsgemäß der 3D-Effekt zugeschaltet und eine neue Peilung mit der Blitzhöhe als zusätzlichem, zu optimierenden Parameter ausgeführt, resultiert ein wesentlich stimmigeres Gesamtergebnis. Die neu eingeführte und optimierte Emissionshöhe, ergibt sich zu 15,7 Kilometem mit einem statistischen Fehler von 3,5 Kilometem. Wird der völlig unabhängige Folgeblitz ebenso analysiert, erhält man einen nahezu identischen Blitzort mit einer Emissionshöhe von 16,4 ± 3,5 Kilometem.

Die geschilderte Verfahrensweise wird auf sämtliche betrachteten Daten angewandt und liefert jeweils vergleichbare Ergebnisse. Um die 3D-Peilung möglichst zuverlässig zu gestalten, besteht die Möglichkeit, nur solche Fälle heranzuziehen, in denen Entladungen an mindestens vier Sensorstationen gemessen werden.

Erfindungsgemäß ist es aber auch möglich, mittels schwächerer, an nur drei Stationen erfasster Signale bei Hinzunahme der Einfallsrichtungen in die Optimtenjngsprozedur eine 3D-Peilung mit hinreichender Genauigkeit durchzuführen.

Tabelle 2 zeigt die Anzahl der im Umkreis um eine Messstation, zum Beispiel um die Zentralstation 10, dreidimensional gepeilten Blitze (= detektierte Signale) und vergleicht diese mit der Gesamtanzahl im Netz gemäß der vorliegenden Erfindung (R bezeichnet den Umkreisradius, Ns die Anzahl der für zweidimensionale Peitungen jeweils benutzten Stationen; unter "H>0" sind die mit mindestens vier Messstationen 20 bzw. 20* dreidimensional gepeilten Signale S bzw. S* mit großen Emissionshöhen H aufgelistet; beetrachtet wird ein exemplarisches Überwachungsgebiet mit Längengraden zwischen 9,5 Grad und 13,3 Grad und mit Breitengraden zwischen 47 Grad und 49,8 Grad):

| R (km) | Ns>=3 | Ns>=4 | H>0 |
|---|---|---|---|
| 20 | 365 | 173 | 36 |
| 30 | 1.459 | 718 | 202 |
| 40 | 5.254 | 2.788 | 540 |
| 50 | 9.088 | 4.851 | 679 |
| 60 | 13.508 | 7.098 | 711 |
| Gesamtgebiet | 60.327 | 36.909 | 2.114 |

Ein Befund lässt sich insofem erkennen, als sich von den im Netz gemäß der vorliegenden Erfindung registrierten Signalen nur ein markanter Anteil höher gelegenen Emissionsorten zuordnen lässt.

Erfindungsgemäß kann mit dem vorliegenden System 100 sowie mit dem diesem System 100 zugrunde liegenden Verfahren auch eine Abgrenzung oder Trennung von Wolkeblitzen (= Entladungen P innerhalb einer Wolke W und/oder zwischen mindestens zwei Wolken W) gegenüber Erdblitzen (= Entladungen P zwischen Wolke W und Erde E) vorgenommen werden.

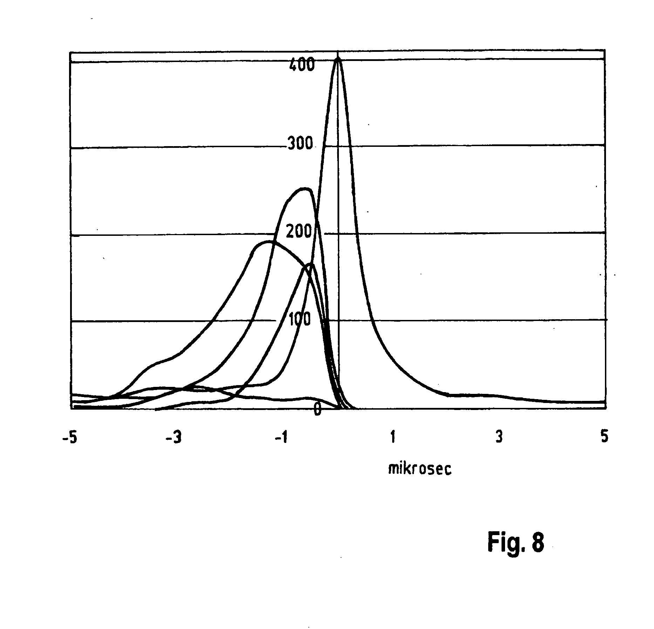

So ist in Figur 8 die um den Zeitnullpunkt (= keine zeitliche Abweichung) symmetrische Kurve als Bodenblitz- oder Erdblitzkurve identifizierbar, das heißt die in Figur 8 symmetrische Kurve zeigt die 4.450 nicht höhenpeilbaren Bodenblitze (C[loud]G[round] *0,26).

Die in Figur 8 dargesteliten weiteren vier Kurven stammen von den Wolkeblkzen, wobei die negativen Zeiten eine Zeltverzögerung bedeuten; diese sind für vier verschiedene Distanzbereiche zwischen Blitz und Sensorstation autgetragen, nämlich
- für den Distanzbereich bis zwanzig Kilometer
   (= Wolkeblitzkurve mit dem niedrigsten Peak In Figur 8),
- für den Distanzbereich zwischen zwanzig und vierzig Kilomebem
   (= Wolkebfitzkurve mit dem drittniedrigsten Peak in Figur 8),
- für den Distanzbereich zwischen vierzig und sechzig Kilometern
   (= Wolkeblitzkurve mit dem viertniedrigsten Peak in Figur 8) und
- für den Distanzbereich über sechzig Kilometer
   (= Wolkeblitzkurve mit dem zweitniedrigsten Peak In Figur 8).

Insgesamt ist in Figur 8 eine Verleilung von 2.247 ermittelten Zeitabwelchungen der jeweils blitznächsten Station bei insgesamt 6.697 gepellten Blitzen dargestellt.

Alles in allem bezieht sich die vorliegende Erfindung auf ein System sowie auf ein Verfahren zur Blitzerkennung, die nicht nur eine erhöhte Effizienz aufweist, sondern auch die erfindungswesentliche Möglichkeit bietet, eine dreidimensionale Unterschetdung von Entladungen innehalb einer Wolke und Wolke-Boden-Entiadungen vorzunehmen:
Während der letzten zwanzig Jahre wurden Systeme zur Blitzlokallsierung für kommerzielle Zwecke hauptsächlich in den USA, aber auch in Frankreich und in Japan entwickelt; diese Entwiddung kulminierte im Aufbau des nordamerikanischen BlitzNachweis-Netzwerks (N[orth]A[merican]L[ightning]D[etection]N[etwork]) im Jahr 1989. Seitdem wurden verschiedene Aufwertungen ausgeruhrt, und die Technik wurde In viele Länder eingeführt

Gemäß dem üblicherweise herangezogenen, eingangs diskutierten Stand der Technik
- werden Effizienzen im Hinblick auf Blilz-Nachweise berichtet, die etwa neunzig Prozent betragen,
- sind die erreichten Lokalisierungsgenauigkeiten besser als ein Kilometer und
- wird die IC-CG-Unterscheidung durch Wellenform-Kriterien als nahezu perfekt bezeichnet.
Bodenblitzdichten werden aus Betriebsergebnlssen berechnet und sollen wichtige Daten für Blitzschutz-Technologien darstellen.

Für modernere Netzwerke wurde konventionellerweise die Möglichkeit einer präzisen Blitzlokalisierung vor allem mittels Messungen überprüft, die Blitze in Radiotürme beinhalteten, dennoch bleibt die Nachwelseffizienz und das Verfahren zur Untersdieldung von IC-Entladung versus CG-Entladung eine durchaus fragwürdige Angelegenheit; so wurden anfänglich Netzwerke entwickelt, die nur auf dem Boden potentiell schadensverursachende CG-Entfadungen anzeigen solften, während IC-Entladungen durch nicht detailllert veröffentlichte Methoden unterdrückt wurden.

Zwar kann angeblich die Anstiegszeit und die Peak-Nulldurchgangszeit der nachgewiesenen VLF-Pulse genutzt werden; wiederholt wurden die relevanten Unterscheldungsparameter in der Vergangenheit jedoch Veränderungen unterzogen. In den letzten Jahren wurde schließlich realisiert, dass IC-Entladungen zumindest metereologisch relevant sind, und somit zeigen moderne Netzwerke auch die nachgewiesenen IC-Blitz-Ereignisse an.

Dementsprechend eröffnet sich erfindungsgemäß eine dreidimensionale Option für die Bestimmung von Emissionshöhen sowie für eine Online-Unterscheidung von C[loud]G[round]- bzw. G[round]C[loud]-Entladungen in Abgrenzung bzw. Im Vergleich zu I[ntra]C[loud]- bzw. C[loud]C[loud]-Entladungen:
Das neue, in Dauerbetrieb überführbare und zum Beispiel In Süd-Ost-Deutschland ein Gebiet von annähernd 300 Kilometern auf 400 Kilometern bedeckende Blitzortungsnetzwerk gemäß der vorliegenden Efindung ermöglicht es, die aufgenommene Btitzaktivität insbesondere In Bezug auf das Auftreten schwerer Gewitter zu analysieren und einen Vergleich mit Daten etablierter Blitzortungsnetzwerke zu ziehen.

Die bernerkenswertesten Ergebnisse können wie folgt gefasst werden:
- Verglichen mit konventlonellen Netzwerken gemäß dem Stand der Technik zeigt das Netzwerk gemäß der vortiegenden Efindung bis zu einer Größenordnung mehr Entladungen an; die meisten zusätzlichen Signale weisen eine niedrigere Amplitude auf.
- Für die Unterscheidung von Entladungen innerhalb einer Wolke (I[ntra]C[loud]) gegenüber Wolke-Boden-Entiadungen (C[loud]G[round]) wird eine neue dreidimensionale Technik angewendet; dies bedeutet unter anderem, dass die konventionelle, mittels Welienform-Kriterien bewerkstelllgte Unterscheidung von IC- und CG-Entladungen In Kenntnis der vorliegenden Erfindung zu modifizleren ist, nicht zuletzt well die meisten lokalisierten Erelgnisse Bodenblitze waren.
- Verglichen mit dem Stand der Technik sind auch die Bodenblitzdichten einer Revision in Richtung höherer Anzahlen zu unterziehen.

Das Netzwerk gemäß der vorliegenden Efindung umfasst zum Beispiel sechs Sensorstationen und ist so ausgelegt, dass es soviel aus aufkommenden Gewittem entstehende V[ery]L[ow]F[requency]-Aktivtät wie möglich misst; hocheffiziente und moderne Datenverarbeitung ist in der vorliegenden Erfindung implementiert, um den metereologisch relevanten Output zu maximieren und um mögliche Chancen für bessere Daten und Informationen in Bezug auf Frühwarnzwecke zu ermitteln.

Als Ergebnis können mittels der vorliegenden Erfindung Blitzenttadungen in viel größeren Mengen als erwartet gesammelt werden. Ein Vergleich mit den Daten konventioneller Netzwerke zeigt einen Überschuss von Faktor drei bis zehn, so dass eine viel bessere Erkennung von Gewitterzellen und Gewitterkonturen möglich wird. Diese Ergebnisse führen zur Frage, woher die zu-sätzlichen Trefter kommen, und geben zu einer detaillierteren Untersuchung der Verfahren für IC-CG-Unterscheidungen Veranlassung.

Da die aus dem Stand der Technik bekannte Methode der Analyse von Wellenformkriterien hochkomplex ist, wird erfindungsgemäß das unmittelbarere Verfahren der 3D-Lokalisierung angewendet, die weder Irgendwelche Annahmen noch irgendwelche anzupassenden Parameter benötigt.

Auf für den Fachmann überraschende Weise erweist sich diese erfindungsgemäße Technik, die bislang in keinem anderen Netzwerk angewendet wurde, als sehr erfolgreich und erlaubt die Identifizierung von IC-Blitzen in annähernd 85 Prozent aller Fälle. Das Prinzip dieser Methode ist im Folgenden dargestellt:
Wenn ein sich ausreichend nahe an einer Entladung befindlicher Sensor ein IC-Ereignis erfasst (im Gegensatz zu einer horizontalen Ausbreitung im Falle eines CG-Gewitterschlags), erhält dieser Sensor das VLF-Signal mit einer Zeitverzögerung dT = T_{P} - T_{H} (vgl. Figur 5). Eine Emissionshöhe von zehn Kilometern verursacht beispielsweise bei einer Sensordistanz von fünfzig Kilometem eine Verzögerung von etwa drei Mikrosekunden.

Da die Genaulgkeit von GPS-basierten Messungen der Ankunftszeiten gewöhnlich in der Größenordnung von einer Mikrosekunde oder besser liegt, ist eine 3D-Unterscheidung von IC-Blitzen möglich, solange der durchschnittliche Abstand der Netzwerksensoren vom Entladungsereignis nicht zu groß ist.

Die Anwendbarkeit der 3D-Methode auf ein vorgegebenes Netzwerk kann mittels einer Untersuchung der Verteilung der Zeitverzögerung P(dT) bestimmt werden, die vom jeweiligen Sensor erhalten wird, der zum lokalisierten Blitz am nächsten gelegen ist. In diesem Zusammenhang schließt die lokalisierung ein, dass die Entladung bei einer ausreichenden Anzahl von Sensorstationen nachgewiesen werden muss.

In Abwesenheit von IC-Entladungen ist P(dT) eine hochsymmetrische Vertellung, während die Existenz von nachweisbaren IC-Entladungen eine Verschlebung der P(dT)-Vertellung zu negativen Zeiten (entsprechend einer zeitlichen Verzögerung) bewirkt (vgl. Figur 8).

Angesichts der letzteren Gegebenheiten kann die Emissionshöhe H als zusätzlicher Parameter in den Lokalisierungsalgorithmus eingeführt werden. Die experimentellen Verteilungen p(dT) gemäß der vorliegenden Erfindung sind tatsächlich asymmetrisch und ergeben typische Ergebnisse. Die hergeleiteten Emissionshöhen von einigen Kilometern erscheinen angemessen, können nicht von CG-Entladungen resultieren und stellen demzufolge wohl IC-Entladungen dar.

In erfindungswesentlicher Weiterbildung werden Netzwerksimulationen genutzt, um die Ergebnisse gemäß der vorliegenden Erfindung zu belastbarer zu machen:
So werden berechnete Ankunftszeiten statistisch deformiert, bis die Genaulgkeit der gesamten Lokalisierung für das Netzwerk zu tatsächlichen Ergebnissen passt und somit zwischen einem halben Kilometer im Zentrum und einem Kilometer in der Nähe der Netzwerkgrenze liegt.

Wenn keine IC-Entladungen angekommen werden, ergeben die künstlichen Zeilverschiebungen in etwa fünfzehn Prozent "falsche" IC-Identifizierungen, während unter der Annahme von einhundert Prozent IC-Enbadungen mit der angenommenen Höhenverteitung 85 Prozent erfasst werden.

Eine Untersuchung der tatsächlichen Datenbeispielfälle gemäß der vorliegenden Erfindung macht deutlich, dass weniger als dreißig Prozent der Ereignisse IC-Entladungen zugeordnet werden können. Als Konsequenz muss dargelegt werden, dass der größte Teil der zusätzlich erfassten Ereignisse CG-Entladungen sind.

Verschiedene Folgerungen der Ergebnisse gemäß der vorliegende Erfindung bedürfen einer weiteren Beachtung:
- Eine neue Technik für IC-CG-Unterscheidungen, die im Prinzip jedes moderne Lokalisierungsnetzwerk bewerkstelligen kann und die neuen Input in Bezug auf die Wolkenphysikforschung gibt, wird zur Verfügung gestellt.
- Die Ergebnisse gemäß der vorliegenden Erfindung können genutzt werden, um die vorstehend erwähnten, an sich bekannten Wellenform-Kriterten zu überprüfen und zu verbessern; es steht zu erwarten, dass eine Kombination der beiden Verfahren eine sehr zuverlässige IC-CG-Unterscheidung ergibt.
- Das Auftreten einer großen Anzahl zusätzlicher Ereignisse erfordert eine Aktualisierung der Nachweiseffizienzen von Netzwerken.
- Der erfindungsgemäß erhaltbare Anstieg von CG-Entladungen erfordert eine Aktualisierung der Kerben von Bodenblitzdichten.

Mit den Ergebnissen der vorliegenden Erfindung können die Wellenform-Kriterien auf eine viel größere Datengrundlage als zuvor hin überprüft werden; auch ist erfindungsgemäß eine Optimierung der Nachwelseffizienz, ein Vergleich mit VHF-Daten anderer hochspezialisierter 3D-Forschungssysteme und eine Untersuchung der Prozesse in Bezug auf IC-Entladungen gewährleistet.

Schließlich erlaubt die Anwendung der erfindungsgemäßen Signalanalyse die Nutzung schwacher und unregelmäßig geformter Blitzimpulse und ermöglicht in allen solchen Fällen eine hinreichend genaue Zelterfassung. Dies führt erwiesenermaßen zu einer erheblichen Verbesserung der Nachweiseffizienz des Blitzmessnetzes sowie neben einer zuverlässigen zweidimensionalen Ortspellung auch zu einer eindeutigen Höhenpellung von Blitzemissionen im VLF-Bereich.

In Ergänzung zu dieser zweidimensionalen Ortspeilung und/oder zu dieser dreidimensionalen Höhenpellung bzw. Direktionalitätspeilung kann gemäß der vorliegenden Erfindung auch mindestens eine der Messstationen 20 bzw. 20* justiert und/oder geeicht werden, wodurch eine verbesserte Zeiterfassung erreicht wird.

Ein derartiges Eich(korrektur)verfahren weist vortellhafterweise folgende Schritte auf.
a) die zweidimensionale Blitzortung wird ohne Einbezug der zu eichenden Station 20 bzw. 20* ausgeführt
b) es wird die Laufzeit vom Blitzort zur betrachteten Station 20 bzw. 20* ermitteih
c) die so ermittelte Signal-Ankunftszeit wird mit der tatsächlich gemessenen Ankunftszeit verglichen;
d) es wird eine Statistik über die unter Schritt c) ermittelten Zeitdifferenzen erstellt;
e) bei korrekter Eichung sollte die Differenz den Mittelwert Null aufweisen und um Null schwanken;
f) es stellt sich im Allgemeinen heraus, dass besagte Differenz einen Trend entweder zu positiven Werten oder zu negativen Werten aufweist; diese Differenz ist der Zeit-Korrekturterm;
g) es ist jedoch darauf zu achten und durch geeignete Maßnahmen zu berücksichtigen, dass eine Signalverzögerung nicht durch Wolke-Wolke-Blitze verursacht wird (vgl. unten) bzw. als solche erkannt wird;
h) bei folgenden Ortungen ist die gemittette Differenz aus Schritt f) als Zeit-Korrektur anzubringen;
i) die besagte Korrektur kann ebenfalls in Abhängigkelt von der Richtung zum Blitzort als Korrekturfunktion ermittelt werden, um gegebenenfalls nicht-isotrope Umgebungseffekte einzubeziehen.

Als Ergebnis der Eichkorrektur bzw. (Nach-)Justierung
- wird die zweidimensionale Ortspeilung verbessert und/oder
- wird bei Einbezug blitznaher Sensorstation(en) die dreidimensionale Höhenpollung hinsichtlich der Wolke-Erde-Blitz-Diskriminierung sicherer, weil noch kleinere Zeitverzögerungen als signifikant zu werten sind; die Höhenpellung wird quantitativ verbessert, well die ermittelten Höhen aufgrund genauerer Zeitdifferenzen ebenfalls automatisch genauer werden.

### Bezugszeichenliste

- 100: System
- 10: Zentralstation oder Zentrale
- 16, 18: Schnittstelle der Zentralstation 10, insbesondere
- 16: Meteosat-Empfänger
- 18: Mailbox eines Wetterdienstes
- 20: einer Impulsquelle räumlich nächstgelegene Messstation oder Sensor(station)
- 20*: einer Impulsquelle räumlich nicht nächstgelegene Messstation oder Sensor(station)
- 22: Datenverarbeitungsanlage, insbesondere P[ersonal]C[omputer]
- 30: Antenne, insbesondere breitbandiger Antennenkörper
- 38: Zeitmesseinrichtung, insbesondere G[lobal]P[ositioning]S[ystem]-Uhr
- 40: Stationselektronik der Zentralstation 10 sowie der Messstation 20, 20*, Insbesondere erstes Sferics-Online-Aufzeichnungssystem der Zentralstation 10
- 40': zweite Stationselektronik der Zentralstation 10, insbesondere zweites Sferics-Online-Aufzeichnungssystem der Zentralstation 10
- 42: Verstärkereinheit der Stationsektronik 40
- 42': Verstärkereinheit der Zentralstation 10
- 44: Filtereinheit der Stationselektronik 40
- 44': Filterereinheit der Zentralstation 10
- 46: A[nalog]/D[igital]-Wandlereinheit der Stationselektronik 40
- 50: Speichereinheit der Messstation 20, 20*
- 60: Verbindung zwischen Zentralstation 10 und Messstation 20, 20*
- 70: Servereinheit der Zentralstation 10, insbesondere zentraler Datenserver und/oder Zeitserver
- 72: der Servereinheit 70 zugeordnete Anzeigeeinheit, zum Beispiel Bildschirm oder Monitor, insbesondere zur Darstellung der aktuellen Sferics-Lage
- 74: F[ourier]T[ransformation] des Signals S, S* mit Online-Darstellung
- 76: Kommunikationszentrum der Zentralstation 10
- 76m: Modern des Kommunikationszentrums 76
- 76w: Wählleitung des Kommunikationszentrums 76
- 78: Online-Darstellung von Satellitenbildem, von Bodenwetterkarten, von Radarwetterkarten und von dergleichen mittels mindestens einer Anzeigeeinheit, insbesondere mittels mindestens eines Bildschirms oder Monitors
- 80: Arbeitsplatz zur Analyse der Daten und Informationen D, D*
- A: Amplitude des Signals S, S*
- C: Direktionalität, insbesondere räumlicher Richtungsvenauf, der Impulsabgabe oder Impulsaussendung
- d: Abstand der Messstationen 20, 20* zueinander
- dT: Laufzeitverzögerung wobei dT = T_{P} - T_{H}
- D: von der einer Impulsquelle räumlich nächstgelegenen Messstation oder Sensor(station) 20 kommende Daten und Informationen
- D*: von der einer Impulsquelle räumlich nicht nächstgelegenen Messstation oder Sensor(station) 20* kommende Daten und Informationen
- E: Erde, insbesondere Erdboden
- H: Höhe der Impulsquelle, insbesondere Emissionshöhe bzw. Sendehöhe
- K: Sender
- M: Flugzeug
- P: atmosphärische Entladung, insbesondere Blitz
- Q: weitere klimatologische und/oder meteorologische Daten- und Informationsquelle
- R: Entfernung der Impulsquelle von der Messstation 20, 20*
- S: der einer Impulsquelle räumlich nächstgelegenen Messstation oder Sensor(station) 20 zugeordnetes Signal
- S*: der einer Impulsquelle räumlich nicht nachstgelegenen Messstation oder Sensor(station) 20* zugeordnetes Signal
- S': mittels der Verstärkereinheit 42 verstärktes Signal
- S": mittels der Filtereinheit 44 gefiltertes Signal
- T_{H}: um Effekt der Höhe H bereinigte Impulsabgabezeit oder Impulsaussendungszeit, insbesondere um Effekt der Höhe H bereinigte Entladungszeit
- T_{P}: Impulsabgabezeit oder Impulsaussendungszeit, insbesondere Entladungszeit
- W: Wolke

## Patentansprüche

1. System (100) zum Erfassen, Übermitteln und Auswerten von durch, insbesondere niedrigfrequente, elektromagnetische Strahlung anfallenden Daten und Informationen (D bzw. D*), aufweisend
- mehrere räumlich getrennte Messstationen (20 bzw. 20*)
-- mit jeweils mindestens einem, insbesondere breitbandigen, Antennenkörper (30) zum Erfassen von der elektromagnetischen Strahlung zuordbaren Signalen (S bzw. S*) sowie
-- mit jeweils mindestens einer Zeitmesseinrichtung (38), insbesondere mindestens einer G[lobal]P[ositioning]S[ystem]-Uhr, zum Ermitteln des jeweiligen zeitlichen Verlaufs, insbesondere der jeweiligen Ankunftszeit, der erfassten Signale (S bzw. S*),
- wobei die elektromagnetische Strahlung aus mindestens einer Impulsquelle natürlichen Ursprungs, insbesondere aus mindestens einer atmosphärischen Entladung (P), stammt und
- wobei
-- die Höhe (H) der Impulsquelle, insbesondere die Emissionshöhe, und
-- die Direktionalität (C), insbesondere der räumliche Richtungsverlauf, der durch die Impulsquelle bewirkten Impulsabgabe oder Impulsaussendung
- lokalisiert wird, indem die Abweichung der Ankunftszeit des Signals (S) an der der Impulsquelle nächstgelegenen Messstation (20) von der Ankunftszeit des Signals (S*) an mindestens einer, vorzugsweise mindestens zwei, derselben Impulsquelle nicht nächstgelegenen Messstationen (20*) bestimmt wird,
**dadurch gekennzeichnet,**
**dass**, insbesondere bei linienförmigen Impuisquellen, die Direktionalität (C) der Impulsabgabe oder Impulsaussendung
- als im Wesentlichen vertikal identifiziert wird, wenn sich die Amplitude (A) des Signals (S bzw. S*) reziprok proportional zur Entfernung (R) der Impulsquelle von derjeweiligen Messstation (20 bzw. 20*) verhält, und
- als im Wesentlichen horizontal identifiziert wird, wenn die Amplitude (A) des Signals (S bzw. S*) von der reziproken Proportionalität abweicht, und diese Abweichung durch Berücksichtigung
-- des Höhenwinkels und
-- des Winkels zwischen Impulsabgabe- oder Impulsaussendungsachse, insbesondere Entladungsachse, und Richtung zur jeweiligen Messstation (20 bzw. 20*)
korrigierbar ist.

2. System gemäß Anspruch 1, **dadurch gekennzeichnet,**
- **dass** mehrere, aus Impulsquellen eines räumlich und/oder zeitlich begrenzten Bereichs stammende Signale (S bzw. S*) zu Gruppen zusammengefasst werden und
- **dass** die Abweichung der Amplitude (A) eines einzelnen Signals (S bzw. S*) zur, insbesondere mittleren, Abweichung der Amplitude (A) der dem Signal (S bzw. S*) zugeordneten Gruppe in Beziehung gesetzt wird, insbesondere um einen durch variable Bodenleitfähigkeit bedingten Dämpfungseffekt zu eliminieren.

3. System gemäß Anspruch 1 oder 2, **dadurch gekennzeichnet, dass** die Impulsabgabe oder Impulsaussendung aus Höhen (H) im Kilometerbereich mittels Vergleichen der an mindestens einer der Impulsquelle nächstgelegenen Messstation (20) und an mindestens zwei derselben Impulsquelle nicht nächstgelegenen Messstationen (20*) gemessenen Verteilungen von Zeitabweichungen (dT) mindestens zweier Impulsabgabe-oder Impulsaussendungzeiten, insbesondere mindestens zweier Entladungszeiten (T_{P}), nachgewiesen wird.

4. System gemäß mindestens einem der Ansprüche 1 bis 3, **dadurch gekennzeichnet, dass** die Höhe (H) der Impulsquelle und die Direktionalität (C) der Impulsabgabe oder Impulsaussendung mittels der der Impulsquelle nächstgelegenen Messstation (20) sowie mittels einer einzigen, der Impulsquelle nicht nächstgelegenen Messstation (20*) bestimmt wird, wenn die Einfallsrichtung der Impulsabgabe oder Impulsaussendung ermittelt wird.

5. System gemäß mindestens einem der Ansprüche 1 bis 4, **dadurch gekennzeichnet, dass** die Messstationen (20 bzw. 20*) jeweils mindestens eine separat vom Antennenkörper (30) angeordnete Stationselektronik (40) zum Verarbeiten der mittels des jeweiligen Antennenkörpers (30) erfassten Signale (S bzw. S*) zu den Daten und Informationen (D bzw. D*) aufweisen, wobei die Stationselektronik (40)
- mindestens eine Verstärkereinheit (42) zum rauscharmen Verstärken der mittels des jeweiligen Antennenkörpers (30) erfassten Signale (S bzw. S*);
- mindestens eine Filtereinheit (44) zum Filtern der mittels der Verstärkereinheit (42) verstärkten Signale (S'), insbesondere im Hinblick auf zum Beispiel von Radiosendern stammende technische Störsignale;
- mindestens eine A[nalog]/D[igital]-Wandlereinheit (46) zum Wandeln der mittels der Filtereinheit (44) gefilterten Signale (S") zu den digitalen Daten und Informationen (D bzw. D*); sowie
- mindestens eine selbstregulierende Schwelle zum Optimieren der Sensitivität der Stationselektronik (40) aufweist.

6. System gemäß mindestens einem der Ansprüche 1 bis 5, **dadurch gekennzeichnet, dass** das Signal (S bzw. S*)
- mit mindestens einer, insbesondere mehrfachen, Zeitmarkierung und/oder mit mindestens einem Zeitraster und/oder mit mindestens einem Zeitstempel versehen und, insbesondere mittels der Verstärkereinheit (42) und/oder mittels der Filtereinheit (44), geglättet sowie optimiert wird und
- hinsichtlich seiner Signaistruktur, insbesondere hinsichtlich seiner oberhalb der selbstregulierenden Schwelle liegenden Signalstruktur, nach dieser Glättung und Optimierung analysiert wird, so dass zum Signal (S bzw. S*), insbesondere in Abhängigkeit von dessen Impulsform, eine Mehr- oder Vielzahl an Zeit- und/oder Strukturinformationen zur Verfügung gestellt wird.

7. System gemäß mindestens einem der Ansprüche 1 bis 6, **dadurch gekennzeichnet,**
- **dass** der Antennenkörper (30) in mechanisch selbsttragender Form ohne bewegliche oder witterungssensitive Komponenten zum Aufstellen im Freien ausgelegt ist,
- **dass** der Primärkreis des Antennenkörpers (30) vom Sekundärkreis des Antennenkörpers (30) galvanisch getrennt ist und
- **dass** die elektromagnetischen Felder breitbandig und rauscharm ausgekoppelt und damit zeitgetreu gemessen werden.

8. System gemäß mindestens einem der Ansprüche 1 bis 7, **dadurch gekennzeichnet, dass** die Messstationen (20 bzw. 20*)
- in einem Abstand (d) von etwa einhundert Kilometern zueinander angeordnet sind und
- jeweils in bidirektionaler, insbesondere drahtgebundener oder drahtloser Verbindung (60) mit einer Zentralstation (10) stehen, an die zumindest ein Teil, insbesondere mindestens ein ausgewählter Parameter, der von der jeweiligen Messstation (20 bzw. 20*) erfassten, verarbeiteten und gespeicherten Daten und Informationen (D bzw. D*) übermittelt wird.

9. System gemäß mindestens einem der Ansprüche 1 bis 8, **gekennzeichnet durch** mindestens eine insbesondere einer Zentralstation (10) zugeordnete Schnittstelle (16, 18) zum Einbinden mindestens einer weiteren klimatologischen oder meteorologischen Daten- und Informationsquelle (Q) zur Charakterisierung der insbesondere mittels M[odel]O[utput]S[tatistics] bewertbaren Gesamtwettersituation.

10. Verfahren zum Erfassen, Übermitteln und Auswerten von durch, insbesondere niedrigfrequente, elektromagnetische Strahlung anfallenden Daten und Informationen (D bzw. D*), wobei die elektromagnetische Strahlung aus mindestens einer Impulsquelle natürlichen Ursprungs, insbesondere aus mindestens einer atmosphärischen Entladung (P), stammt, bei welchem Verfahren
[i] der elektromagnetischen Strahlung zuordbare Signale (S bzw. S*) mittels mehrerer räumlich getrennter Messstationen (20 bzw. 20*), mit jeweils mindestens einem, beispielsweise breitbandigen, der jeweiligen Messstation (20 bzw. 20*) zugeordneten Antennenkörper (30), erfasst werden,
[ii] der jeweilige zeitliche Verlauf, insbesondere die jeweilige Ankunftszeit, der erfassten Signale (S bzw. S*) mittels mindestens einer der jeweiligen Messstation (20 bzw. 20*) zugeordneten Zeitmesseinrichtung (38), insbesondere mittels mindestens einer GPS-Uhr, ermittelt wird und
[iii] die Höhe (H) der Impulsquelle, insbesondere die Emissionshöhe, und die Direktionalität (C), insbesondere der räumliche Richtungsverlauf, der durch die Impulsquelle bewirkten Impulsabgabe lokalisiert wird, indem die Abweichung der Ankunftszeit des Signals (S) an der der Impulsquelle nächstgelegenen Messstation (20) von der Ankunftszeit des Signals (S*) an mindestens einer, vorzugsweise mindestens zwei, derselben Impulsquelle nicht nächstgelegenen Messstationen (20*) bestimmt wird.
**dadurch gekennzeichnet,**
**dass** die Direktionalität (C) der Impulsabgabe oder Impulsaussendung
- als im Wesentlichen vertikal identifiziert wird, wenn sich die Amplitude (A) des Signals (S bzw. S*) reziprok proportional zur Entfernung (R) der Impulsquelle von der jeweiligen Messstation (20 bzw. 20*) verhält, und
- als im Wesentlichen horizontal identifiziert wird, wenn die Amplitude (A) des Signals (S bzw. S*) von der reziproken Proportionalität abweicht, und diese Abweichung durch Berücksichtigung
-- des Höhenwinkels und
-- des Winkels zwischen Impulsabgabe- oder Impulsaussendungsachse, insbesondere Entladungsachse, und Richtung zurjeweiligen Messstation (20 bzw. 20*)
korrigiert werden kann.

11. Verfahren gemäß Anspruch 10, **dadurch gekennzeichnet, dass** Impulsabgaben oder Impulsaussendungen, insbesondere Entladungen (P), innerhalb einer Wolke (W) oder zwischen mindestens zwei Wolken (W) von Impulsabgaben oder Impulsaussendungen, insbesondere Entladungen (P), zwischen Wolke (W) und Erde (E) unterschieden werden.

12. Verfahren gemäß Anspruch 10 oder 11, **dadurch gekennzeichnet, dass** mittels mindestens einer Stationselektronik (40)
- die typischerweise in einzelnen Wellenzügen auftretende elektromagnetische Strahlung in Bezug auf ihre spektralen Eigenschaften mittels F[ast]F[ourier]T[ransformation] analysiert wird,
- der jeweilige zeitliche Verlauf der Signale (S bzw. S*) bei variablen Pulsformen vollständig erfasst wird,
- auch bei hohen Signalraten sämtliche Signale (S bzw. S*) totzeitfrei erfasst werden und/oder,
- insbesondere auf Basis mindestens eines Algorithmus, signalspezifische Parameter zum Klassifizierten sowie Zuordnen der Signale (S bzw. S*) zu bestimmten atmosphärischen Vorgängen ermittelt werden.

13. Verfahren gemäß mindestens einem der Ansprüche 10 bis 12, **dadurch gekennzeichnet,**
- **dass** die an den Messstationen (20 bzw. 20*) ankommenden Signale (S bzw. S*) mit mindestens einer exakten Zeitmarkierung versehen werden, insbesondere Signale (S bzw. S*) derselben Impulsquelle einheitlich zeitmarkiert werden, und
- **dass** die Abweichung der Ankunftszeit des Signals (S) an der der Impulsquelle nächstgelegenen Messstation (20) von der Ankunftszeit des Signals (S*) an den derselben Impulsquelle nicht nächstgelegenen Messstationen (20*) mit Hilfe der Zeitmarkierung bestimmt wird.

14. Verfahren gemäß mindestens einem der Ansprüche 10 bis 13, **dadurch gekennzeichnet, dass** ergänzend zum Lokalisieren der Höhe (H) der Impulsquelle und der Direktionalität (C) der Impulsabgabe (= Verfahrensschritt [iii] in Anspruch 10) mindestens eine der Messstationen (20 bzw. 20*) justiert oder geeicht wird.

15. Verfahren gemäß Anspruch 14, **dadurch gekennzeichnet, dass**
[iii.a] die Position, insbesondere der Ort und die Höhe, der Impulsquelle lokalisiert wird, indem unter Ausschluss der zu justierenden oder zu eichenden Messstation (20 bzw. 20*) aus dem ermittelten jeweiligen zeitlichen Verlauf, insbesondere der ermittelten jeweiligen Ankunftszeit, der jeweilige Laufzeitunterschied von Impulsen derselben Impulsquelle zur jeweiligen Messstation (20 bzw. 20*) ermittelt wird,
[iv] der jeweilige zeitliche Verlauf, insbesondere die jeweilige Ankunftszeit, der von der lokalisierten Impulsquelle stammenden und an der zu justierenden oder zu eichenden Messstation (20 bzw. 20*) erfassten Signale (S bzw. S*) berechnet wird,
[v] die Differenz zwischen dem berechneten jeweiligen zeitlichen Verlauf, insbesondere der berechneten jeweiligen Ankunftszeit, und dem ermittelten jeweiligen zeitlichen Verlauf, insbesondere der ermittelten jeweiligen Ankunftszeit, der von der lokalisierten Impulsquelle stammenden und an der zu justierenden oder zu eichenden Messstation (20 bzw. 20*) erfassten Signale (S bzw. S*) ermittelt sowie in statistisch aussagekräftiger Weise aufbereitet wird und
[vi] erforderlichenfalls
[vi.a] aufgrund der ermittelten jeweiligen Differenz mindestens ein Zeitkorrekturterm, insbesondere für spätere Lokalisierungen oder Ortungen, ermittelt wird sowie
[vi.b] die zu justierende oder zu eichende Messstation (20 bzw. 20*) mittels dieses ermittelten Zeitkorrekturterms justiert oder geeicht wird.

16. Verwendung mindestens eines Systems (100) gemäß mindestens einem der Ansprüche 1 bis 9 oder eines Verfahrens gemäß mindestens einem der Ansprüche 10 bis 15
- zur Lokalisierung
-- der Höhe (H) der Impulsquelle, insbesondere der Emissionshöhe, und
-- der Direktionalität (C), insbesondere des räumlichen Richtungsverlaufs, der durch die Impulsquelle bewirkten Impulsabgabe oder Impulsaussendung,
- zum Eichen oder zum Justieren mindestens einer der Messstationen (20 bzw. 20*),
- zur Abgrenzung von Impulsabgaben oder Impulsaussendungen, insbesondere Entladungen (P), innerhalb einer Wolke (W) oder zwischen mindestens zwei Wolken (W) gegenüber Impulsabgaben oder Impulsaussendungen, insbesondere Entladungen (P), zwischen Wolke (W) und Erde (E),
- zur Erstellung von Blitzdichtekarten, oder
- zur genauen Zeit- und/oder Strukturerfassung der Impulse,
auch unter Nutzung schwacher und/oder unregelmäßig geformter Blitzimpulse.

## Claims

1. A system (100) for recording, transmitting and analyzing data and information (D or D*) accrued from, in particular low-frequency, electromagnetic radiation, comprising
- several spatially separated measuring stations (20 or 20*)
-- with at least one respective, in particular broadband, antenna body (30), for recording signals (S or S*) which are assignable to the electromagnetic radiation, and
-- with at least one respective time measurement facility (38), in particular at least one respective G[lobal]P[ositioning]S[ystem] clock for determining the respective time progression, in particular the respective arrival time, of the recorded signals (S or S*),
- wherein the electromagnetic radiation originates from at least one impulse source of natural origin, in particular from at least one atmospheric discharge (P), and
- wherein
-- the altitude (H) of the impulse source, in particular the emission altitude, and
-- the directionality (C), in particular the spatial direction path, of the impulse emission or impulse broadcast caused by the impulse source
- is localized in that the deviation of the arrival time of the signal (S) on the measuring station (20) located closest to the impulse source from the arrival time of the signal (S*) on at least one, preferably at least two, measuring stations (20*) which are not located closest to said impulse source, is determined,
**characterized in**
**that** in particular with line-formed impulse sources, the directionality (C) of the impulse emission or impulse broadcast
- is identified as being essentially vertical, when the amplitude (A) of the signal (S or S*) is reciprocally proportional to the distance (R) between the impulse source and the respective measuring station (20 or 20*), and
- is identified as being essentially horizontal, when the amplitude (A) of the signal (S or S*) deviates from the reciprocal proportionality, and this deviation is correctable by taking into account
-- the altitude angle, and
-- the angle between the impulse emission or impulse broadcast axis, in particular the discharge axis and the direction to the respective measuring station (20 or 20*).

2. The system according to claim 1, **characterized in**
- **that** several signals (S or S*) which originate from impulse sources in a spatially limited and/or time limited range are combined, and
- **that** the deviation of the amplitude (A) of an individual signal (S or S*) in particular for providing the average deviation of the amplitude (A), is correlated with the group assigned to the signal (S or S*), in particular in order to eliminate a damping effect conditional upon a variable ground conductivity.

3. The system according to claim 1 or 2, **characterized in that** the impulse emission or impulse broadcast from altitudes (H) in the kilometre range is detected by means of comparing the distributions of time deviations (dT) of at least two impulse emission or impulse broadcast times, in particular of at least two discharge times (T_{P}), said distributions being measured on at least one measuring station (20) located closest to the impulse source, and on at least two measuring stations (20*) which are not located closest to said impulse source.

4. The system according to at least one of claims 1 to 3, **characterized in that** the altitude (H) of the impulse source and the directionality (C) of the impulse emission or impulse broadcast is determined by means of a single measuring station (20) which is located closest to the impulse source, and by means of a single measuring station (20*) which is not located closest to the impulse source, when the incident direction of the impulse emission or impulse broadcast is determined.

5. The system according to at least one of claims 1 to 4, **characterized in that** the measuring stations (20 or 20*) each comprise at least one station electronic system (40) which is arranged separately from the antenna body (30) for processing the signals (S or S*) from the data or information (D or D*) which are recorded by means of the antenna body (30) in question, wherein the station electronic system (40) comprises
- at least one amplification unit (42) for the low-noise amplification of the signals (S or S*) recorded by means of the antenna body (30) in question;
- at least one filter unit (44) for filtering the signals (S') amplified by means of the amplification unit (42), in particular with regard to technical interference signals for example originating from radio transmitters;
- at least one A[nalog]/D[igital] converter unit (46) for converting the signals (S") from the digital data and information (D or D*) which have been filtered by means of the filter unit (44); and
- at least one self-regulating threshold for optimizing the sensitivity of the station electronic system (40).

6. The system according to at least one of claims 1 to 5, **characterized in that** the signal (S or S*)
- is provided with at least one, in particular multiple, time identification and/or with at least one time grid and/or with at least one time stamp, and is leveled as well as optimized, in particular by means of the amplification unit (42) and/or by means of the filter unit (44), and
- with regard to its signal structure, in particular with regard to its signal structure lying above the self-regulating threshold, is analyzed following this leveling and optimization, so that for the signal (S or S*), in particular in dependence on its impulse form, a plurality or large number of time and/or structural information is provided.

7. The system according to at least one of claims 1 to 6, **characterized in**
- **that** the antenna body (30) is designed for installation in the open air in a mechanically self-supporting form, without movable or weather-sensitive components,
- **that** the primary circuit of the antenna body (30) is galvanically separated from the secondary circuit of the antenna body (30), and
- **that** the electromagnetic fields are decoupled with broad band and with low noise, and therefore are measured with time accuracy.

8. The system according to at least one of claims 1 to 7, **characterized in that** the measuring stations (20 or 20*)
- are arranged at a distance (d) of approximately one hundred kilometres from each other, and
- respectively stand in bi-directional, in particular wired or wireless connection (60), with a central station (10), to which at least a part, in particular at least one selected parameter, of the data and information (D or D*) which is recorded, processed and stored by the respective measuring stations (20 or 20*) is accrued.

9. The system according to at least one of claims 1 to 8, **characterized by** at least one interface (16, 18) for incorporating at least one further climatological or meteorological data and information source (Q) for characterizing the overall weather situation which in particular can be evaluated by means of M[odel]O[utput]S[tatistics], in particular with the interface (16, 18) being assigned to a central station (10).

10. A method for recording, transmitting and analyzing data and information (D or D*) accrued from, in particular low-frequency, electromagnetic radiation, where the electromagnetic radiation originates from at least one impulse source of natural origin, in particular from at least one atmospheric discharge (P), in which method
[i] signals (S or S*) which are assignable to the electromagnetic radiation are recorded by means of several spatially separated measuring stations (20 or 20*) respectively comprising at least one, for example broad band, antenna body (30) which is assigned to the respective measuring station (20 or 20*),
[ii] the respective time progression, in particular the respective arrival time, of the recorded signals (S or S*) is determined by means of at least one time measurement facility (38), in particular by means of at least one GPS clock, which is assigned to the respective measuring station (20 or 20*), and
[iii] the altitude (H) of the impulse source, in particular the emission altitude, and the directional information (C), in particular the spatial direction path, of the impulse emission created by the impulse source is localized by determining the difference between the arrival time of the signal (S) at the measuring station (20) located closest to the impulse source and the arrival time of the signal (S*) at at least one, preferably at least two, measuring stations (20*) which are not located closest to said impulse source,
**characterized in**
**that** the directional information (C) of the impulse emission or impulse broadcast
- is identified as being essentially vertical, when the amplitude (A) of the signal (S or S*) is reciprocally proportional to the distance (R) between the impulse source and the respective measuring station (20 or 20*), and
- is identified as being essentially horizontal, when the amplitude (A) of the signal (S or S*) deviates from the reciprocal proportionality, and this deviation can be corrected by taking into account
-- the altitude angle, and
-- the angle between the impulse emission or impulse broadcast axis, in particular discharge axis, and the direction to the respective measuring station (20 or 20*).

11. The method according to claim 10, **characterized in that** impulse emissions or impulse broadcasts, in particular discharges (P), within a cloud (W) or between at least two clouds (W) are differentiated from impulse emissions or impulse broadcasts, in particular discharges (P), between the cloud (W) and the earth (E).

12. The method according to claim 10 or 11, **characterized in that** by means of at least one station electronic system (40)
- the electromagnetic radiation which typically occurs in individual waves is analyzed in relation to its spectral properties by means of F[ast]F[ourier]T[ransformation],
- the respective time progression of the signals (S or S*) is recorded in full with variable pulse forms,
- even with high signal rates, all signals (S or S*) are recorded with no down time, and/or
- in particular on the basis of at least one algorithm, signal-specific parameters for classifying and assigning the signals (S or S*) to specific atmospheric processes are determined.

13. The method according to at least one of claims 10 to 12, **characterized in**
- **that** the signals (S or S*) which arrive at the measuring stations (20 or 20*) are provided with at least one precise time identification, in particular signals (S or S*) from the same impulse source are given uniform time identifications, and
- **that** the deviation of the arrival time of the signal (S) at the measuring station (20) located closest to the impulse source from the arrival time of the signal (S*) at the measuring stations (20*) not located closest to the impulse source is determined by means of time identification.

14. The method according to at least one of claims 10 to 13, **characterized in that** in addition to the localization of the altitude (H) of the impulse source and the directional information (C) of the impulse emission (= method step [iii] in claim 10), at least one of the measuring stations (20 or 20*) is adjusted or calibrated.

15. The method according to claim 14, **characterized in that**
[iii.a] the position, in particular the location and the altitude, of the impulse source is localized **in that**, to the exclusion of the measuring station (20 or 20*) to be adjusted or to be calibrated, the respective difference of runtime of impulses from the same impulse source to the respective measuring station (20 or 20*) is determined from the calculated respective time progression, in particular from the calculated respective arrival time,
[iv] the respective time progression, in particular the respective arrival time, of the signals (S or S*) originating from the localized impulse source and recorded on the measuring station (20 or 20*) to be adjusted or to be calibrated is calculated,
[v] the difference between the calculated respective time progression, in particular the calculated respective arrival time, and the determined respective time progression, in particular the determined respective arrival time, of the signals (S or S*) originating from the localized impulse source and recorded on the measuring station (20 or 20*) to be adjusted or to be calibrated is determined and prepared in a statistically meaningful manner, and
[vi] if necessary
[vi.a] due to the determined respective difference, at least one time correction term, in particular for later localizations or positioning procedures, is determined, and
[vi.b] the measuring station (20 or 20*) to be adjusted or to be calibrated is adjusted or calibrated by means of this determined time correction term.

16. Use of at least one system (100) according to at least one of claims 1 to 9 or of a method according to at least one of claims 10 to 15
- for the localization
-- of the altitude (H) of the impulse source, in particular of the emission altitude, and
-- of the directionality (C), in particular of the spatial directional path, of the impulse emission or impulse broadcast caused by the impulse source
- for calibrating or for adjusting at least one of the measuring stations (20 or 20*),
- for the delimitation of impulse emissions or impulse broadcasts, in particular discharges (P), within a cloud (W) or between at least two clouds (W) as opposed to impulse emissions or impulse broadcasts, in particular discharges (P), between cloud (W) and earth (E),
- for producing lightning density maps, or
- for precisely recording the time and/or structure of the impulses,
even when weak and/or irregularly formed lightning impulses are used.

## Revendications

1. Système (100) pour détecter, transmettre et évaluer des données et des informations (D ou D*) générées par un rayonnement électromagnétique, en particulier de faible fréquence, présentant
- plusieurs stations de mesure (20 ou 20*) séparées spatialement
-- avec respectivement un corps d'antenne (30), en particulier à large bande, pour détecter des signaux (S ou S*) pouvant être attribués au rayonnement électromagnétique ainsi
-- qu'avec au moins un dispositif de mesure du temps (38), en particulier au moins une montre à G[lobal]P[ositioning]S[ystem], pour déterminer la variation dans le temps respective, en particulier le moment d'arrivée respectif, des signaux détectés (S ou S*),
- le rayonnement électromagnétique provenant d'au moins une source d'impulsions d'origine naturelle, en particulier d'au moins une décharge atmosphérique (P), et
- moyennant quoi
-- la hauteur (H) de la source d'impulsions, en particulier la hauteur d'émission, et
-- la directionnalité (C), en particulier la variation de direction dans l'espace, de l'émission d'impulsions ou de l'envoi d'impulsions générée par la source d'impulsions
- sont localisées en ce que l'on détermine l'écart entre le moment d'arrivée du signal (S) à la station de mesure (20) la plus proche de la source d'impulsions et le moment d'arrivée du signal (S*) à au moins une station de mesure, de préférence à deux stations de mesure (20*) qui ne sont pas les plus proches de ladite source d'impulsions,
**caractérisé en ce**
**que**, en particulier en cas de sources d'impulsions de forme linéaire, la directionnalité (C) de l'émission d'impulsions ou de l'envoi d'impulsions
- est identifiée comme étant sensiblement verticale lorsque l'amplitude (A) du signal (S ou S*) se comporte de manière proportionnellement réciproque par rapport à la distance (R) entre la source d'impulsions et la station de mesure (20 ou 20*) respective, et
- est identifiée comme étant sensiblement horizontale lorsque l'amplitude (A) du signal (S ou S*) varie par rapport à la proportionnalité réciproque, et cet écart pouvant être corrigé en tenant compte
-- de l'angle d'élévation et
-- de l'angle entre l'axe d'émission d'impulsions ou d'envoi d'impulsions, en particulier l'axe de décharge, et la direction par rapport à la station de mesure (20 ou 20*) respective.

2. Système selon la revendication 1, **caractérisé en ce que**,
- plusieurs signaux (S ou S*) provenant de sources d'impulsions d'une zone délimitée dans l'espace et/ou dans le temps sont assemblés en groupes et
- **en ce que** l'écart de l'amplitude (A) d'un signal individuel (S ou S*) est mis en rapport avec, en particulier, l'écart moyen de l'amplitude (A) du groupe associé au signal (S ou S*), en particulier afin d'éliminer un effet d'atténuation relevant d'une capacité de conduction variable du sol.

3. Système selon les revendications 1 ou 2, **caractérisé en ce que** l'émission d'impulsions ou l'envoi d'impulsions à partir de hauteurs (H) de l'ordre des kilomètres est prouvée grâce à une comparaison des répartitions d'écarts de temps (dT), mesurées au niveau d'au moins l'une des stations de mesures (20) la plus proche de la source d'impulsions et au niveau d'au moins deux stations de mesure (20*) non situées le plus près de cette même source d'impulsions, d'au moins deux temps d'émission d'impulsions ou d'envoi d'impulsions, en particulier d'au moins deux temps de décharge (T_{P}).

4. Système selon l'une au moins des revendications 1 à 3, **caractérisé en ce que** la hauteur (H) de la source d'impulsions et la directionnalité (C) de l'émission d'impulsions ou de l'envoi d'impulsions sont déterminées à l'aide de la station de mesure (20) la plus proche de la source d'impulsions ainsi qu'à l'aide d'une seule station de mesure (20*) qui n'est pas la plus proche de la source d'impulsions, lorsque l'on détermine la direction d'incidence de l'émission d'impulsions ou de l'envoi d'impulsions.

5. Système selon l'une au moins des revendications 1 à 4, **caractérisé en ce que** les stations de mesure (20 ou 20*) présentent respectivement au moins une électronique de station (40) disposée indépendamment du corps d'antenne (30) pour le traitement des signaux (S ou S*) détectés à l'aide du corps d'antenne (30) respectif concernant les données et informations (D ou D*), moyennant quoi l'électronique de station (40) présente
- au moins une unité d'amplification (42) pour l'amplification à faible bruit des signaux (S ou S*) détectés à l'aide du corps d'antenne (30) respectif;
- au moins une unité de filtrage (44) pour le filtrage des signaux (S') amplifiés à l'aide de l'unité d'amplification (42), en particulier en ce qui concerne des signaux d'interférence techniques provenant par exemple d'émetteurs radio;
- au moins une unité de conversion A[nalogique] /N[umérique] (46) pour la conversion des signaux (S") filtrés à l'aide de l'unité de filtrage (44) concernant les données et informations numériques (D ou D*); ainsi que
- au moins un seuil autorégulateur pour l'optimisation de la sensibilité de l'électronique de station (40).

6. Système selon l'une au moins des revendications 1 à 5, **caractérisé en ce que** le signal (S ou S*)
- est muni d'au moins un marquage temporel, en particulier multiple, et/ou d'au moins une grille de temps et/ou d'au moins une marque temporelle, et est lissé ainsi qu'optimisé, en particulier à l'aide de l'unité d'amplification (42) et/ou à l'aide de l'unité de filtrage (44), et
- est analysé après ce lissage et cette optimisation, en particulier en ce qui concerne sa structure de signal, en particulier en ce qui concerne sa structure de signal se situant au-dessus du seuil autorégulateur, de sorte que l'on met à disposition pour ce signal (S ou S*), en particulier en fonction de la forme d'impulsion de celui-ci, de multiples ou nombreuses informations de temps et/ou de structure.

7. Système selon l'une au moins des revendications 1 à 6, **caractérisé en ce que**
- le corps d'antenne (30) est conçu sous une forme mécaniquement autoportante sans composants mobiles ou sensibles aux intempéries pour la mise en place à l'extérieur,
- **en ce que** le circuit primaire du corps d'antenne (30) est séparé de manière galvanique du circuit secondaire du corps d'antenne (30) et
- **en ce que** les champs électromagnétiques sont découplés avec une large bande et un faible bruit et sont ainsi mesurés de manière fidèle dans le temps.

8. Système selon l'une au moins des revendications 1 à 7, **caractérisé en ce que** les stations de mesure (20 ou 20*)
- sont disposées à une distance (d) d'environ cent kilomètres les unes par rapport aux autres et
- sont respectivement en liaison (60) bidirectionnelle, en particulier filaire ou sans fil, avec une station centrale (10) à laquelle on transmet au moins une partie, en particulier au moins un paramètre choisi, des données et informations (D ou D*) détectées, traitées et enregistrées par la station de mesure (20 ou 20*) respective.

9. Système selon l'une au moins des revendications 1 à 8, **caractérisé par** au moins une interface (16, 18) associée en particulier à une station centrale (10) pour l'intégration d'au moins une autre source d'informations et de données climatologiques ou météorologiques (Q) pour la caractérisation de la situation météorologique globale évaluable en particulier à l'aide de M[odel]O[utput]S[tatistics].

10. Procédé pour détecter, transmettre et évaluer des données et des informations (D ou D*) générées par un rayonnement électromagnétique, en particulier de faible fréquence, le rayonnement électromagnétique provenant d'au moins une source d'impulsions d'origine naturelle, en particulier d'au moins une décharge atmosphérique (P), dans lequel procédé
[i] on détecte des signaux (S ou S*) pouvant être associés au rayonnement électromagnétique à l'aide de plusieurs stations de mesure (20 ou 20*) séparées dans l'espace, avec respectivement un corps d'antenne (30), par exemple à large bande, associé à la station de mesure (20 ou 20*) respective,
[ii] la variation dans le temps respective, en particulier le moment d'arrivée respectif des signaux (S ou S*) détectés étant déterminé à l'aide d'au moins l'un des dispositifs de mesure de temps (38) associé à la station de mesure (20 ou 20*) respective, en particulier à l'aide d'une montre à GPS, et
[iii] la hauteur (H) de la source d'impulsions, en particulier la hauteur d'émission, et la directionnalité (C), en particulier la variation de direction dans l'espace de l'émission d'impulsions provoquée par la source d'impulsions, étant localisée en détectant l'écart entre le moment d'arrivée du signal (S) à la station de mesure (20) la plus proche de la source d'impulsions et le moment d'arrivée du signal (S*) à au moins une station de mesure, de préférence à au moins deux stations de mesure (20*) qui ne sont pas les plus proches de cette même source d'impulsions,
**caractérisé en ce**
**que** la directionnalité (C) de l'émission d'impulsions ou de l'envoi d'impulsions
- est identifiée comme étant sensiblement verticale lorsque l'amplitude (A) du signal (S ou S*) se comporte de manière proportionnellement réciproque par rapport à la distance (R) entre la source d'impulsions et la station de mesure (20 ou 20*) respective, et
- est identifiée comme étant sensiblement horizontale lorsque l'amplitude (A) du signal (S ou S*) varie par rapport à la proportionnalité réciproque, et cet écart pouvant être corrigé en tenant compte
-- de l'angle d'élévation et
-- de l'angle entre l'axe d'émission d'impulsions ou d'envoi d'impulsions, en particulier l'axe de décharge, et la direction par rapport à la station de mesure (20 ou 20*) respective.

11. Procédé selon la revendication 10, **caractérisé en ce que** l'on effectue une distinction entre des émissions d'impulsions ou envois d'impulsions, en particulier des décharges (P), au sein d'un nuage (W) ou bien entre au moins deux nuages (W), et des émissions d'impulsions ou envois d'impulsions, en particulier des décharges (P), entre des nuages (W) et la terre.

12. Procédé selon les revendications 10 ou 11, **caractérisé en ce que**, à l'aide d'au moins une électronique de station (40)
- on analyse le rayonnement électromagnétique apparaissant typiquement dans des trains d'ondes individuels en ce qui concerne ses propriétés spectrales à l'aide d'une F[ast]F[ourier]T[ransformation] (transformation rapide de Fourier),
- la variation dans le temps respective des signaux (S ou S*) étant entièrement détectée en cas de formes d'impulsions variables,
- l'ensemble des signaux (S ou S*) étant détectés sans temps mort également en cas de débits de signaux élevés et/ou,
- en particulier sur la base d'au moins un algorithme, des paramètres spécifiques aux signaux pour la classification tout comme l'association des signaux (S ou S*) étant identifiés pour la détermination des évènements atmosphériques.

13. Procédé selon l'une au moins des revendications 10 à 12, **caractérisé en ce que**
- les signaux (S ou S*) arrivant aux stations de mesure (20 ou 20*) sont munis d'au moins un marquage temporel exact, en particulier des signaux (S ou S*) de la même source d'impulsions étant soumis à un marquage temporel de manière uniforme, et
- **en ce que** l'écart entre le moment d'arrivée du signal (S) à la station de mesure (20) la plus proche de la source d'impulsions et le moment d'arrivée du signal (S*) aux stations de mesure (20*) qui ne sont pas les plus proches de cette même source d'impulsions, est déterminé à l'aide du marquage temporel.

14. Procédé selon l'une au moins des revendications 10 à 13, **caractérisé en ce que**, de manière complémentaire à la localisation de la hauteur (H) de la source d'impulsions et de la directionnalité (C) de l'émission d'impulsions (= étape [iii] du procédé de la revendication 10), au moins l'une des stations de mesure (20 ou 20*) est réglée ou étalonnée.

15. Procédé selon la revendication 14, **caractérisé en ce que**
[iii.a] on localise la position, en particulier l'emplacement et la hauteur de la source d'impulsions, en déterminant, en excluant la station de mesure (20 ou 20*) à régler ou à étalonner, à partir de la variation dans le temps respective déterminée, en particulier du moment d'arrivée respectif déterminé, la différence de durée respective d'impulsions de la même source d'impulsions vers la station de mesure (20 ou 20*) respective,
[iv] la variation dans le temps respective, en particulier le moment d'arrivée respectif, des signaux (S ou S*) provenant de la source d'impulsions localisée et détectés au niveau de la station de mesure (20 ou 20*) à régler ou à étalonner, étant mesurée,
[v] la différence entre la variation dans le temps respective calculée, en particulier le moment d'arrivée respectif calculé, et la variation dans le temps respective déterminée, en particulier le moment d'arrivée respectif déterminé, des signaux (S ou S*) provenant de la source d'impulsions localisée et détectés au niveau de la station de mesure (20 ou 20*) à régler ou à étalonner, étant déterminée ainsi que présentée d'une manière pertinente du point de vue statistique et
[vi] le cas échéant
[vi.a] du fait de la différence respective déterminée, au moins un terme de correction de temps étant déterminé en particulier pour des localisations ou repérages ultérieurs, et
[vi.b] la station de mesure (20 ou 20*) à régler ou étalonner, étant réglée ou étalonnée à l'aide de ce terme de correction de temps déterminé.

16. Utilisation d'au moins un système (100) selon l'une au moins des revendications 1 à 9 ou d'un procédé selon l'une au moins des revendications 10 à 15
- pour la localisation
-- de la hauteur (H) de la source d'impulsions, en particulier de la hauteur d'émission, et
-- de la directionnalité (C), en particulier de la variation de direction dans l'espace, de l'émission d'impulsions ou de l'envoi d'impulsions provoqué(e) par la source d'impulsions
- pour régler ou étalonner au moins l'une des stations de mesure (20 ou 20*),
- afin de délimiter des émissions d'impulsions ou des envois d'impulsions, en particulier des décharges (P), au sein d'un nuage (W) ou entre au moins deux nuages (W), par rapport à des émissions d'impulsions ou des envois d'impulsions, en particulier des décharges (P), entre nuage (W) et terre (E),
- afin d'établir des cartes de densité d'éclairs, ou
- pour la détection précise du temps et/ou de la structure des impulsions,
en utilisant également des impulsions d'éclairs formées de manière faible et/ou irrégulière.
